# EUROPEAN PATENT APPLICATION

(11) **EP 2 555 594 A1**
(43) Date of publication of application: **06.02.2013**
(21) Application number: 11765470.7
(22) Date of filing: 28.03.2011
(51) Int. Cl.: H05B 33/10, G09F 9/00, G09F 9/30, H01L 21/336, H01L 27/32, H01L 29/786, H01L 51/05, H01L 51/42, H01L 51/50

(54) **DONOR SUBSTRATE FOR TRANSFER, DEVICE MANUFACTURING METHOD AND ORGANIC ELEMENT**

(30) Priority: 31.03.2010 JP 2010080697
(71) Applicant: Toray Industries, Inc., Tokyo 103-8666 (JP)
(72) Inventor: TANIMURA, Yasuaki, Otsu-shi Shiga 520-8558 (JP); FUJIMORI, Shigeo, Tokyo 1038666 (JP); NISHIMURA, Seiichiro, Otsu-shi Shiga 520-8558 (JP)
(74) Representative: Hoefer & Partner
(86) International application number: PCT/JP2011/057523
(87) International publication number: WO 2011/125570

(57) **Abstract**

Disclosed is a donor substrate that can manufacture a high-performance, organic EL element even when using a transfer method, and a device that includes a high-performance, organic EL element with few impurities.

## Description

### TECHNICAL FIELD

The present invention relates to a donor substrate, for transfer, used for patterning a thin film constituting a device, examples of which typically include organic EL elements and further include organic TFTs, photoelectric transducers, and various sensors; and a device manufacturing method wherein this donor substrate for transfer is used.

### BACKGROUND ART

The organic EL element is an element wherein electrons injected from a cathode are recombined with holes injected from an anode in an organic emissive layer sandwiched between both electrodes. From a time when C. W. Tang et al. of Kodak Co., Ltd. showed that organic EL elements emit light with a high luminance, many research institutions have been investigating.

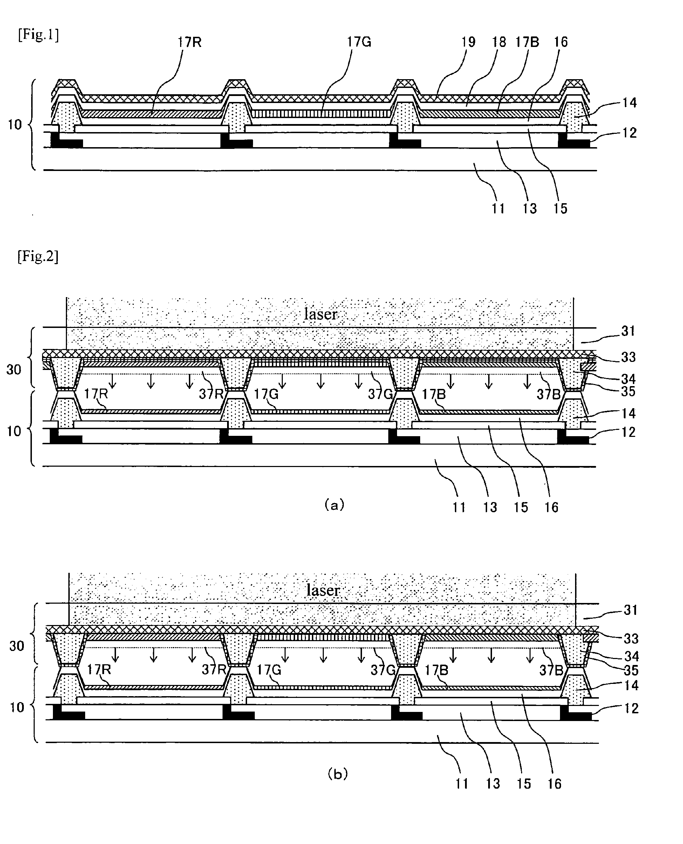

This light emission element is thin, and can give a high-luminance emission at a low driving voltage and can further give many luminescent colors, typically, the three primary colors of red (R), green (G) and blue (B), by use of various organic materials in its emissive layers. Thus, practical use of this element for a color display has been advancing. In, for example, an active matrix type color display illustrated in Fig. 1, required is a technique of patterning at least emissive layers 17R, 17G and 17B with a high precision to be caused to correspond to sub-pixels of R, G and B, respectively, which constitute each pixel. In order to realize a high-performance organic EL element, a multi-layered structure is required, and it is necessary to laminate a hole injection layer, a hole transporting layer, an emissive layer, an electron transporting layer, an electron injection layer, and others successively, a typical film thickness of each of these layers being 0.1 µm or less.

For fine patterning of a thin film, a wet process (painting process), such as photolithography, ink-jet printing or printing, has hitherto been used. However, in the wet process, at the time of painting, for example, a photoresist or an ink onto a previously-formed underlayer, it is difficult to prevent completely a change in the form of the underlayer, which is very thin, undesired mixing, and others. Thus, usable materials are limited. It is also difficult to attain an evenness in the film thickness of the thin film, which is formed by drying from a solution, inside pixels, and an evenness between the pixels in the substrate. Thus, following an unevenness in the film thickness, the concentration of electric current or a degradation in the element is caused to result in a problem that the element is degraded in the performance for a display.

As a patterning method based on a dry process without using any wet process, a mask vapor deposition process has been investigated. Emissive layers of small-size organic EL displays put actually into practical use are patterned exclusively through the present process. However, for a vapor deposition mask, it is necessary to make precise holes in a metal plate. Thus, it is difficult to make an increase in the size of the mask and the precision thereof compatible with each other. As the mask becomes larger in size, a close adhesiveness of the vapor deposition mask onto a substrate tends to be further damaged. It is therefore difficult to apply this process to large-size organic EL displays.

In order to realize an increase in the size through a dry process, disclosed is a method of patterning an organic EL material on a donor film beforehand, and heating the whole of the donor film in the state that a device substrate is caused to adhere closely onto the organic EL material on the donor film, thereby transferring the organic EL material onto the device substrate (see Patent Document 1). Disclosed is also a vapor deposition transfer process of opposing an organic EL material patterned in regions inward from a division pattern (division wall) to a device substrate in such an arrangement that these do not contact each other, and heating the whole of the donor substrate on a hot plate, thereby vaporizing the organic EL material to be deposited onto the device substrate (see Patent Document 2). However, according to the methods, the whole of the donor substrate is heated to be thermally swelled so that a relative location of the organic EL material patterned on the donor substrate to the device substrate is changed and further as the device becomes larger in size, the quantity of this dislocation becomes larger so that highly precise patterning is not easily attained. In the addition to these problems, the device substrate opposed with a small interval is heated by radiation, or when the opposed members have a division pattern, the device substrate receives an effect of outgas from the division pattern, and others to result in a problem that the device performance is degraded.

As a method for preventing the dislocation of a donor substrate by thermal swelling, developed is a selective transfer process of forming a light-to-heat conversion layer (LHCL) onto the donor substrate, depositing an organic EL material on the entire front surface thereof by thermal vapor deposition, radiating a high-intensity laser partially onto the LHCL to generate heat, and using the heat to pattern-transfer, onto a device substrate, portions of the organic EL material formed on the entire front surface, or to pattern-transfer, onto a device substrate, portions of organic EL materials painted, without using any division pattern, to be divided into R, G and B (see Patent Documents 3 and 4) . However, the generated heat diffuses in the horizontal direction also, so that the organic EL material (s) on an area wider than the laser-irradiated range is/are transferred. Boundaries therebetween are also unclear. In order to prevent this, it is conceivable that a high-intensity laser is irradiated in a very short period. In this case, however, the organic EL material(s) is/are heated in the very short period; thus, the highest arrival temperature is not precisely controlled with ease. This matter makes higher the possibility that the temperature of the organic EL material (s) arrives at the decomposition temperature or higher, resulting in a problem that the device performance is declined. Furthermore, it is necessary to irradiate the laser selectively for the R sub-pixels independently of the other sub-pixels, as well as the G and B sub-pixels. This causes a problem that as (device) substrates each become large in size to increase the total number of the pixels, the period for processing each of the substrates becomes long.

As another method for preventing the dislocation of the donor substrate by the thermal swelling, disclosed is a direct heating transfer process of heating an organic EL material on a donor substrate directly with a laser without forming a LHCL in the donor substrate (see Patent Document 5). In addition, R, G and B are painted to be divided from each other in Patent Document 5 to decrease the possibility of the mixing of the colors at the patterning time. However, a typical film thickness of the organic EL material is 25 nm, which is very thin; thus, the laser arrives at the device substrate without being sufficiently absorbed therein, resulting in a problem of heating an underlayer laid on the device substrate. In order to heat the organic EL material at the sublimation temperature or higher to attain the transfer sufficiently, a high-intensity laser is essential. However, when the laser is irradiated onto the division pattern, the division pattern is degraded. It is therefore necessary for the prevention of the degradation to attain a highly precision alignment to irradiate the laser only onto the organic EL material. As a result, it is difficult to increase the size of the device.

Disclosed is also a method of forming an LHCL onto a donor substrate, painting thereon organic EL materials of R, G and B to be divided from each other, irradiating a laser onto the LHCL to transfer the materials at a time to prevent a dislocation of the donor substrate based on thermal swelling (see Patent Document 6). However, no division pattern is formed on the donor substrate to cause a problem that when the R, G and B materials are each painted in a solution state, any one of the materials may be mixed with any adjacent one thereof, or when the painted films are dried, any one of the materials may again dissolve any adjacent one thereof by solvent vapor. Thus, it is difficult to paint the organic EL materials to be divided from each other with a high precision. For this reason, disclosed are also methods of locating a division pattern onto a donor substrate, and painting organic EL materials to be divided from each other with a high precision (see Patent Documents 7 and 8).

### PRIOR ART DOCUMENTS

### PATENT DOCUMENTS

Patent Document 1: JP-A-2002-260854
Patent Document 2: JP-A-2000-195665
Patent Document 3: JP-B1-3789991
Patent Document 4: JP-A-2005-149823
Patent Document 5: JP-A-2004-87143
Patent Document 6: JP-A-2008-235011
Patent Document 7: JP-A-2009-146715
Patent Document 8: WO 2009/154156

### SUMMARY OF THE INVENTION

### PROBLEMS TO BE SOLVED BY THE INVENTION

As described above, it is possible to locate a division pattern onto a donor substrate, paint organic EL materials to be divided from each other with a high precision, and then transfer the materials in order to make an increase in the size compatible with the precision. However, elements each obtained by transferring emissive materials by use of a donor substrate produced by a method in the prior art may not be sufficient in performance as compared with elements obtained by vapor deposition. The inventors have repeatedly made investigations about this problem to find out that a cause of a degradation in the performance of an element yielded after the transfer is a matter that when an emissive material is painted into regions inward from a division pattern on a donor substrate, impurities elute out from the material of the division pattern to be mixed with the emissive material.

Thus, an object of the invention is to solve the problems and supply a donor substrate making it possible that also when a transfer process is used, a high-performance organic EL element is manufactured; and a device, typically a high-performance organic EL element, wherein the quantity of impurities is small.

### SOLUTIONS TO THE PROBLEMS

The invention is a donor substrate for transfer, comprising: a substrate, a light-to-heat conversion layer formed over the substrate, and a division pattern that is at least partially formed over an upper surface of the light-to-heat conversion layer, wherein a barrier layer is formed over a front surface of the division pattern to form a transfer layer in regions inward from the division pattern.

### EFFECTS OF THE INVENTION

The invention makes it possible to decrease largely impurities incorporated into a thin film, which is typically made of an organic EL material, and attain not only an increase in the size of an element but also fine patterning. Thus, the invention produces remarkably advantageous effects of an improvement of the element in luminance and lifetime.

### BRIEF DESCRIPTION OF THE DRAWINGS

Fig. 1 is a sectional view illustrating an example of an organic EL element wherein an emissive layer is patterned by transfer using the donor substrate of the invention.
Figs. 2 are each a sectional view illustrating an example of a method for patterning an emissive layer of an organic EL element by transfer using the donor substrate of the invention.
Fig. 3 is a plan view illustrating an example of a light irradiating method in Figs. 2.
Figs. 4 are each a sectional view illustrating a transfer using the donor substrate of the invention.
Figs. 5 are each a sectional view illustrating an example of a design of a liquid repellent treatment layer in the donor substrate of the invention.
Figs. 6 are each a plan view illustrating another example of the design of the liquid repellent treatment layer in the donor substrate of the invention.
Figs. 7 are each a perspective view illustrating an example of a light irradiating method.
Figs. 8 are each a perspective view illustrating an example of the light irradiating method.
Fig. 9 is a perspective view illustrating an example of the light irradiating method.
Fig. 10 is a perspective view illustrating an example of the light irradiating method.
Figs. 11 are each a sectional view referred to in order to describe a difference in the patterning precision of emissive layers between the technique of the invention and the prior art.
Figs. 12 are each a sectional view referred to in order to describe a difference in the edge form of an emissive layer between transfer process and vapor deposition process.
Figs. 13 are each a sectional view illustrating an example of the structure of a donor substrate suitable for manufacturing the organic EL element of the invention.

### EMBODIMENTS FOR CARRYING OUT THE INVENTION

Figs. 2, Fig. 3 and Figs. 4 are sectional views and a plan view illustrating examples a thin film patterning method using the donor substrate of the invention. Many ones of the figures used in the present specification are each illustrated in the state that one or more minimum units composed of RGB sub-pixels are picked out, the unit(s) constituting each of many pixels in a color display. For the assist of understanding, the magnification for enlargement in the vertical direction (substrate vertical direction) is made larger than that in the horizontal direction (substrate in-plane direction).

In Figs. 2, a donor substrate 30 is composed of a support 31, a light-to-heat conversion layer (LHCL) 33, a division pattern 34, a barrier layer 35, and transfer materials 37 (respective painted films of RGB emissive materials of an organic EL) present in regions inward from the division pattern. For example, an embodiment wherein the barrier layer is formed on the whole of the front surface of the donor substrate is illustrated in Fig. 2 (a) ; and an embodiment wherein the barrier layer is formed only on the division pattern is illustrated in Fig. 2(b). An organic EL element (device substrate) 10 is composed of a support 11, each TFT (including leading-out electrodes) 12 and a flattening layer 13 formed thereon, an insulating layer 14, each first electrode 15, and each hole transporting layer 16. These are examples; thus, as will be described later, the structure of each of the substrates is not limited to the above.

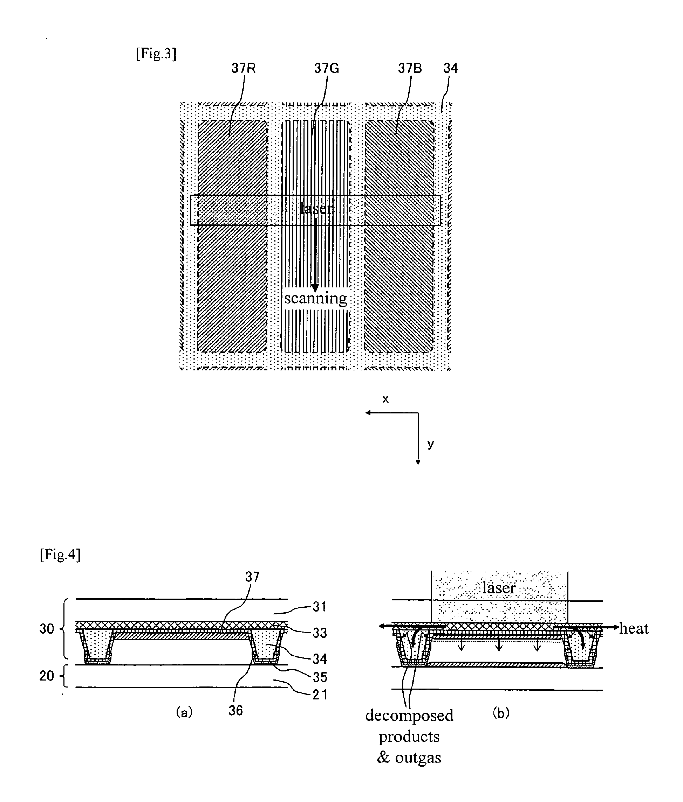

In the patterning method, first, in the state that the position of the division pattern 34 of the donor substrate 30 is made consistent with that of the insulating layer 14 of the device substrate 10, the two substrates are arranged to be opposed to each other. Next, a laser is irradiated into the donor substrate 30 from the support 31 side thereof to be absorbed into the LHCL 33. By heat generated therein, the transfer materials 37R, 37G and 37B are simultaneously heated and vaporized so that these are deposited on the hole transporting layer 16 of the device substrate 10. In this way, any one 17R out of emissive layers 17R, plus one 17G out of emissive layers 17G, and one 17B out of emissive layers 17B, are formed at a time by the transferring. The embodiments in Figs. 2 and 3 are characterized in that the laser is irradiated to heat not only the whole of the area of the division pattern 34 that is sandwiched between the transfer materials 37R, 37G and 37B but also partial areas of the division pattern 34 that are positioned outside the transfer materials 37R and 37B, simultaneously, together with the transfer materials 37.

Fig. 3 is a schematic view obtained when the situation in each of Figs. 2 is viewed from the support 31 side of the donor substrate 30. Since the LHCL 33 formed in the entire surface is present, the division pattern 34 and the transfer materials 37R, 37G and 37B are not actually viewed from the support 31 (glass plate) side; however, these are illustrated by dot lines to demonstrate the positional relationship thereof with the laser. The beam of the laser is rectangular, and is irradiated to stride the transfer materials 37R, 37G and 37B and further scanned in a direction perpendicular to the line of the transfer materials 37R, 37G and 37B. The laser beam needs only to be relatively scanned. Thus, the laser may be shifted, or a set of the donor substrate 30 and the device substrate 20 may be shifted. Both of these shifts may be performed.

Figs. 4 are each a schematic sectional view when the transfer materials 37 are transferred with the laser. The laser irradiated into the donor substrate 30 from the support side 31 of the substrate 30 heats the transfer materials 37 through the LHCL 33 so that the transfer materials 37 can be transferred onto the device substrate. The heat from the LHCL is conducted to the division pattern 34; however, the division pattern is not heated at its region contacting the device side members. Thus, the device side members are not thermally degraded.

However, at the interface between the division pattern and the LHCL, outgas and decomposed products are easily generated. Thus, when the donor substrate is repeatedly used, impurity components elute out in a solvent in which the transfer materials are dissolved, and then, these components are transferred, together with the transfer materials, to the device substrate, or other inconveniences are caused. As a result, the device, such as the organic EL element, is degraded in performance. This fact has been understood. The elution-out of the impurities may be caused whether the division pattern is made of an organic material or inorganic material. When the pattern is made of an organic material, the elution-out is particularly easily caused.

In the method illustrated in Figs. 2 to Figs. 4, the barrier layer 35 is laid on the division pattern. This manner makes it possible to prevent the elution-out of impurities from the division pattern (the elution-out of impurities contained in the division pattern, and the elution-out of the division-pattern-constituting-material itself). Even when a light ray is irradiated to heat the transfer materials and the division pattern simultaneously, restriction into a minimum level can be attained about a bad effect resulting from outgas of the division pattern, and others onto the device performance.

Moreover, about the division pattern, a highly precise patterning can be attained by, for example, photolithography; thus, gaps between respective transfer patterns of different ones out of the transfer materials can be made into a minimum level. This matter makes the present device higher in aperture ratio, resulting in an advantageous effect that an organic EL display excellent in lifetime can be manufactured.

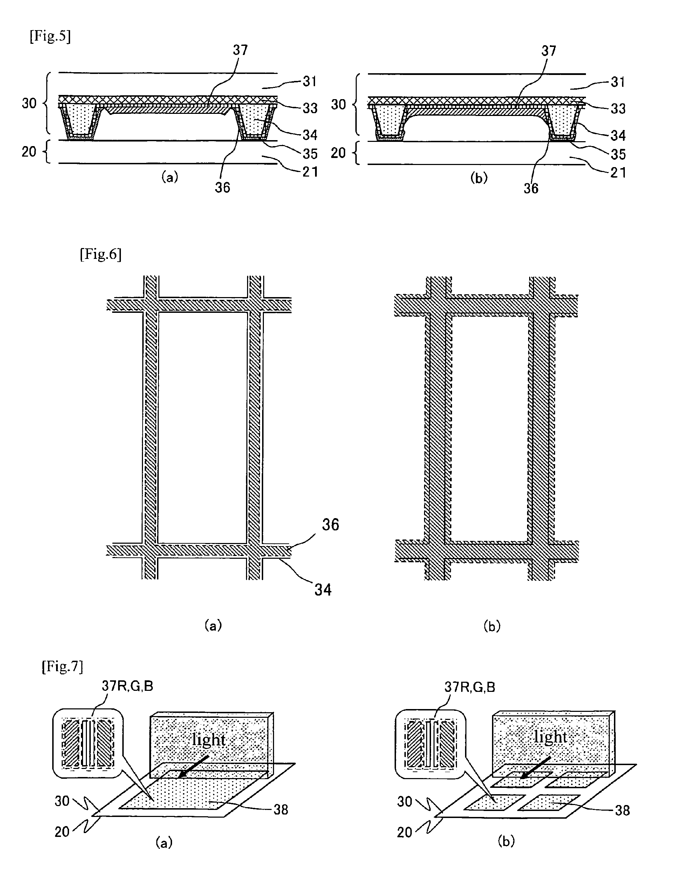

As illustrated in Figs. 5 and Figs. 6, in each further developed embodiment of the invention, a liquid repellent treatment layer 36 is formed on a barrier layer 35 on a division pattern. The cases in Fig. 5(a) and Fig. 6(a) are each a case where the liquid repellent treatment layer is designed to be made larger in the width of its any portion than the division pattern. After transfer materials are painted, the solvent therein remains in regions inward from the division pattern, so that the solvent is not painted on the division pattern. Thus, the transfer materials can be effectively used. The cases in Fig. 5(b) and Fig. 6 (b) are each a case where the liquid repellent treatment layer is designed to be made smaller in the width of its any portion than the division pattern. Since the transfer materials spread also onto edges of the division pattern to wet the edges, the transfer materials are used in a slightly excessive amount; however, the uniformity of the wetting in the regions inward from the division pattern is improved. This matter makes it possible to improve the films after the transfer thereof in thickness-uniformity. Either of these cases may be used in accordance with the situation. The solvent is repelled on the liquid repellent treatment layer, so that the solvent painted on any one of the regions inward from the division pattern spreads onto the barrier layer to wet the layer. As a result, it is possible to prevent a matter that the solvent invades a division adjacent to the division pattern (the generation of color-mixing). This matter is applied to a case where the interval between any adjacent two regions of the division pattern is made narrow. Accordingly, each of the transfer materials can be precisely painted into the individual regions inward from the division pattern. In particular, in a pattern high in precision and highly narrow in the width of its any portion, two or more colors can be painted to be divided from each other. The division pattern can be designed to be made narrower in the width of its any portion than the insulating layer of the device side members; thus, this embodiment has a great advantageous effect that the transfer material can be more evenly transferred onto the device substrate than embodiments in the prior art.

Hereinafter, the invention will be described in more detail.

### (1) Irradiating light ray

A preferred example of the light source for the irradiating light ray is a laser, which easily gives a high intensity and emits a light ray excellent in shape-controllability. The light source may be, for example, an infrared lamp, a tungsten lamp, a halogen lamp, a xenon lamp, or a flash lamp. The laser may be a known laser, such as a semiconductor laser, a fiber laser, YAG laser, argon laser, nitrogen laser, or an excimer laser. Since an object of the invention is to decrease a damage onto the transfer materials, a continuous wave mode (CW) laser is more preferred than an intermittent oscillation mode (pulse) laser.

The wavelength of the irradiating light ray is not particularly limited as far as the wavelength is a wavelength that is slightly absorbed in an atmosphere for the irradiation, and the support of the donor substrate, and is effectively absorbed into the LHCL. Accordingly, light rays from ultraviolet rays to infrared rays may be used besides visible ray range rays. When a preferred material of the support of the donor substrate is considered, the wavelength range is, for example, preferably from 300 nm to 5 µm, more preferably from 380 nm to 2 µm.

The shape of the irradiating light ray is not limited to the rectangle illustrated in Fig. 3. In accordance with conditions for the transfer, an optimal shape can be selected from linear, elliptic, square, polygonal, and other shapes. The irradiating light ray may be created by combining light rays from plural light sources with each other. Reversely, a ray from a single light source can be divided into plural irradiating light rays. The scanning speed is not particularly limited. In general, a speed ranging from 0.01 to 2 m/s is preferably used. When the irradiation intensity of the light ray is relatively small and the light ray is scanned at a lower speed to decrease a damage onto the transfer material, the scanning speed is preferably 0.6 m/s or less, more preferably 0.3 m/s or less.

When in division transfer, in which scanning onto the sample area is repeated to attain full transfer, the number of times of dividing is increased to keep the whole at a low temperature, it is preferred to set the scanning speed to 0.3 m/s or more, which is a relatively high speed, in order to decrease heat quantity introduced per scanning operation. In this case, the number of the times of the dividing is preferably from 2 to 50 for the following reason: if the number is too small, heat of the molecules at the transfer time degrades the hole transporting layer of the device side members; and if the number is too large, the productivity is declined and further the total heat quantity introduced becomes large to degrade the organic molecules of the device side members and the donor side members.

The embodiment for irradiating the light ray is not limited to any embodiment as illustrated in Figs. 2 to Figs. 4, wherein the whole of the division pattern 34 region sandwiched between the transfer materials 37R, 37G and 37B, as well as the partial regions of the division pattern 34 that are positioned outside the transfer materials 37R and 37B, is simultaneously heated together with the transfer materials 37. Examples of other embodiments include an embodiment wherein a light ray having an appropriate width is irradiated while scanned (an example of the ray being a light ray having a width permitting simultaneous heating of at least one portion of the transfer materials 37 and at least one portion of the division pattern 34); and an embodiment wherein a light ray covering a constant-proportion area in the transfer area is irradiated step by step. Of course, embodiments other than these embodiments are allowable.

Some specific examples thereof are described. As illustrated in Fig. 7(a), when the irradiating area is large, a light ray is irradiated which covers the total width of a transfer area 38 of a donor substrate 30, thereby making it possible to transfer all the transfer materials at a time by a single scanning. In this layout, alignment for the light irradiation onto the donor substrate 30 can be largely relieved. As illustrated in Fig. 7(b), when plural transfer areas 38 are present in a substrate, these areas can be transferred at a time. Even when individual sub-pixels of RGB are not arranged in a straight line, which is called delta arrangement, the irradiating light ray can be straightly scanned so that the transfer can easily attained.

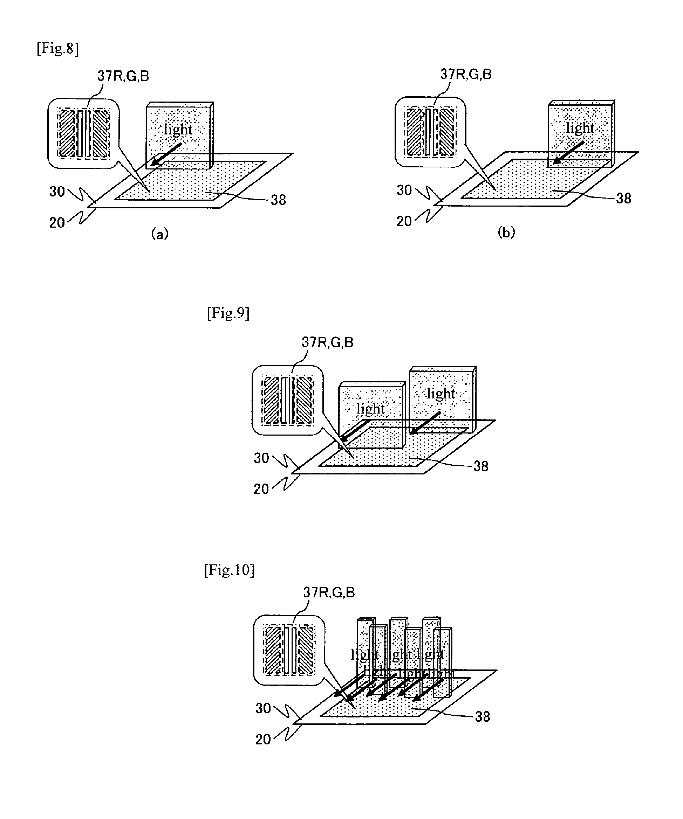

As illustrated in Fig. 8(a), when the irradiation area is substantially a half of a transfer area 38 of a donor substrate 30, a light ray is irradiated onto the transfer area 38 of the substrate 30 to cover about a half of the width of the transfer area 38. As illustrated in Fig. 8(b), in the next scanning, the light ray is irradiated onto the other half. Thus, by the two scanning operations, the entire transfer materials can be transferred. Furthermore, as illustrated in Fig. 9, two light rays having a positional relationship that these rays are shifted from each other in the scanning direction are simultaneously scanned, whereby transfer materials 37 can be transferred, similarly to the case according to the above-mentioned two scanning operations. From restriction based on the maximum power of the light source, the evenness of the light ray, and others, a single light ray covering the entire width of the transfer area 38 may not be easily obtained; even in this case, this simultaneous scanning makes it possible to transfer all the transfer materials at a time in a manner mimically equivalent to the one-scanning operation. Of course, as illustrated in Fig. 10, when the width of each of light rays is made narrower and the number thereof is increased, the same advantageous effects can be gained.

Respective preferred ranges of the irradiation intensity and the heating temperature of the transfer material are affected by various conditions. Examples of the conditions include the uniformity of the irradiating light ray; the irradiating period (scanning speed); the respective materials, thicknesses or reflectivities of the support and the LHCL of the donor substrate; the material or shape of the division pattern; and the material or thickness of the transfer material. In the invention, a standard aim is to prepare conditions such that the energy density absorbed in the LHCL is adjusted into the range of 0.01 to 10 J/cm² and the transfer material is heated into the range of 220 to 400°C.

### (2) Donor Substrate

The support of the donor substrate is not particularly limited as far as the support is a support that is small in light absorptivity, and that is a matter over which an LHCL, a division pattern and a transfer material can be stably formed. In accordance with the situation, a resin film can be used. Examples of the material of the resin include polyester, polyethylene, polyethylene terephthalate, polyethylene naphthalate, polycarbonate, polyacrylic resin, polysulfone, polyethersulfone, polyphenylenesulfide, polyimide, polyamide, polybenzooxazole, polyepoxy, polypropylene, polyolefin, aramide resin, and silicone resin.

A preferred example of the support is a glass plate from the viewpoint of chemical and thermal stabilities, dimension stability, mechanical strength, and transparency. In accordance with the situation, the glass thereof may be selected from sodium lime glass, non-alkali glass, lead-containing glass, borosilicate glass, aluminosilicate glass, low-expansive glass, quartz glass, and others. When transfer process in the invention is carried out in a vacuum, outgas from the support is required to be slight; thus, a glass plate is a particularly preferred support.

The front surface of the glass may be coated with a coupling agent that may be of various types. This manner makes it possible to improve the glass in adhesiveness onto the LHCL. As the coupling agent, known are Si-based, Al-based, Ti-based, Zn-based and other coupling agents. Any one thereof may be used. A coupling agent having a large effect of adhering onto the metal or oxide of the LHCL is preferably, for example, an aminosilane coupling agent, a mercaptosilane coupling agent.

Even when the LHCL is heated to a high temperature, a rise in the temperature (thermal swelling) of the support itself needs to be controlled into a predetermined range. Thus, it is preferred that the support is sufficiently larger in thermal capacity than the LHCL. Accordingly, the thickness of the support is preferably 10 times or more that of the LHCL. A permissible range thereof depends on the size of the transfer area, the required precision of the patterning, and others; thus, the range is not described without reservation. For example, in a case where when the LHCL is raised in temperature from room temperature to 300°C so that the support is heated by the diffusion of the heat, the temperature rise in the support itself is desired to be controlled into 3°C, which is 1/100 of the temperature rise in the LHCL, or less, the thickness of the support is preferably 100 times or more that of the LHCL when the LHCL and the support are substantially equal to each other in volume thermal capacity. When the temperature rise in the support itself is desired to be controlled into 1°C, which is 1/300 of the temperature raise in the LHCL, or less, the thickness of the support is more preferably 300 times or more that of the LHCL. In a typical case where the volume of thermal capacity of the LHCL is about 2 times that of the support, the thickness of the support is preferably 200 times or more that of the LHCL, more preferably 600 times or more. This manner makes it possible that even when the device is made large in size, the quantity of a change in the dimension by thermal swelling is made small, thereby attaining highly precise patterning.

The LHCL is not particularly limited as far as the material and the structure thereof permit this layer to absorb light efficiently to generate heat, and to be stable against the generated heat. The LHCL may be, for example, a thin film wherein, for example, carbon black, graphite, titanium black, an organic pigment or metal particles are dispersed in resin; or an inorganic thin film such as a metal thin film. Since the LHCL may be heated to about 300°C in the invention, the LHCL is preferably an inorganic thin film excellent in heat resistance. From the viewpoint of light absorption, and film-formability, the LHCL is in particular preferably a metal thin film. The metal matter thereof may be a thin film made of a single metal or an alloy, or a laminated thin film of such films; examples of the metal, or metals of the alloy include tungsten, tantalum, niobium, manganese, molybdenum, titanium, chromium, gold, silver, copper, platinum, iron, zinc, aluminum, cobalt, nickel, magnesium, vanadium, silicon, and carbon.

If necessary, an antireflective layer may be formed on the support side of the LHCL. Furthermore, an antireflective layer may be formed on the light-incidence side surface of the support. These antireflective layers are each preferably an optical interference thin film using a refractive index difference, and may be a thin film made of a single material or a mixture, or a laminated thin film of such films; examples of the material, or materials of the mixture include silicon, silicon oxide, silicon nitride, zinc oxide, magnesium oxide, and titanium oxide.

The LHCL needs to give a sufficient heat for the vaporization of the transfer material. It is therefore preferred that the LHCL is larger in thermal capacity than the transfer material. Thus, the thickness of the LHCL is preferably larger than that of the transfer material, and is more preferably 5 times or more that of the transfer material. The numerical value thereof is from 0.02 to 2 µm, more preferably from 0.1 to 1 µm. The LHCL preferably absorbs 90% or more of the irradiated light ray, more preferably 95% or more; thus, it is preferred to design the thickness of the LHCL to satisfy this condition.

In order to restrain a matter that a light ray irradiated into the LHCL is reflected toward the incidence side thereof to decrease the light absorption efficiency of the LHCL, an antireflective layer may be laid between the support and the LHCL. The antireflective layer is preferably a laminated body of layers high in transparency and largely different in refractive index difference. This manner generates multiple reflection on the interface between the layers largely different from each other in refractive index. Thus, when the thickness of the antireflective layer is adjusted to be matched with the incident wavelength, the reflection of the incident light ray can be largely decreased by use of optical interference. Since heat from the LHCL is conducted also to this antireflective layer, the material of the antireflective layer is preferably a material that easily generates thermal stress therein and is high in adhesiveness to the support. Examples thereof include metal oxides, and metal sulfides, such as Al₂O₃, Bi₂O₃, CaO, CdO, CdS, CeO₂, Fe₂O₃, Fe₃O₄, La₂O₃, Nd₂O₃, Sb₂O₃, Sb₂S₃, SiO, Si₂O, SnO₂, TiO₂, ThO₂, WO₃, ZnS, and ZrO₂. However, the material is not limited to these compounds. When the antireflective layer is formed, it is preferred to design the layer to be made thin in order not to hinder an efficient conduction of heat generated in the LHCL to the transfer material as far as the layer satisfies a required function.

As far as the LHCL is formed in a region where the transfer material is present, the planar shape thereof is not particularly limited. As has been described in the above-mentioned examples, the LHCL may be formed on the entire surface of the donor substrate. For example, when the division pattern is good in adhesiveness to the support but poor in that to the LHCL, the LHCL may be patterned to be discontinuous underneath the division pattern so that the division pattern contacts at least one portion of the support. When the LHCL is patterned, the pattern thereof does not need to be made into a shape equivalent to that of the division pattern. For example, the division pattern may be in a lattice form while the LHCL may be in a stripe form. The LHCL is large in light absorptivity; thus, it is preferred to use the LHCL to form a position mark of the donor substrate at an appropriate position inside or outside the transfer area.

For the method for forming the LHCL or the antireflective layer, a known technique may be used in accordance with the materials, examples thereof including spin coating, slit-nozzle coating, a vacuum deposition process, an EB vapor deposition process, sputtering and ion plating. For attaining the patterning, for example, a known photolithographic process or laser ablative sublimation may be used.

The division pattern is not particularly limited as far as the material and the structure thereof permit the pattern to define a boundary for the transfer material and to be stable against heat generated in the LHCL. An inorganic material therefor is, for example, an oxide or a nitride, typical examples of which include silicon oxide and silicon nitride, a glass, or a ceramic material. An organic material therefor is, for example, a resin such as polyvinyl, polyimide, polybenzooxazole, polystyrene, acrylic resin, Novolack, or silicone. A glass paste material usable in division walls of a plasma television may be used to form the division pattern in the invention. The thermal conductivity of the division pattern is not particularly limited, and is preferably a small thermal conductivity, such as that of an organic substance, to prevent heat from diffusing through the division pattern to the opposed device substrate. Furthermore, polyimide and polybenzooxazole are given as examples of a preferred material that is excellent also in patterning property and heat resistance.

Repeating investigations, the inventors have found out that a large cause for decreasing the performance of an element produced through transfer process is impurities eluting out from the division-pattern-constituting materials, in particular, the resin components. It is conceivable that examples of the impurities include a photosensitizer contained in the photosensitive materials, unreacted low-molecular-weight organic components, water, and ionic elements. It is considered that, in particular, free ionic elements cause a problem. For this reason, the invention provides a means for restraining the elution-out of impurities from the division pattern.

The method for forming a film as the division pattern is not particularly limited. When an inorganic material is used, use may be made of a vacuum deposition process, an EB vapor deposition process, sputtering, ion plating, CVD, laser ablative sublimation or some other known technique. When an organic material is used, use may be made of spin coating, slit-nozzle coating, dip coating or some other known technique. The patterning method for the division pattern is not particularly limited, and, for example, a known photolithographic process may be used. The patterning for the division pattern may be attained by an etching (or lift-off) method using a photoresist. By using a material obtained by giving photosensitivity to any one of the above-described resin material examples to expose the division pattern directly to light, and then developing the workpiece, the patterning may be attained. Furthermore, use may be made of, for example, a stamping method or imprinting method wherein a mold is pushed against the layer of the division pattern formed over the entire surface; or ink-jet or nozzle-jet printing, and other various printing methods wherein a resin material is directly patterned.

The form of the division pattern is not limited to the lattice-form structure which has already been illustrated in Fig. 3. For example, when the three transfer materials 37R, 37G and 37B are formed on the donor substrate 30, the planar form of the division pattern 34 may be stripes extended in the Y direction thereof.

The thickness of the division pattern is not particularly limited. The thickness of the division pattern is preferably larger than that of the transfer material, and is also preferably from 1 to 100 µm, more preferably from 2 to 20 µm since it is preferred that the transfer material does not directly contact the transfer-receiving surface of the device substrate and further it is preferred that the interval between the transfer material of the donor substrate and the transfer-receiving surface of the donor substrate is kept in the range of 1 to 100 µm, in particular in the range of 2 to 20 µm. When the transfer material is painted in the regions inward from the division pattern, the painting needs to be performed to cause the solvent not to overflow from the division pattern. For this requirement, the division pattern is preferably thicker to be preferably 4 µm or more in thickness. By opposing the division pattern having such a thickness to the device substrate, it becomes easy to keep, into a constant value, the interval between the transfer material of the donor substrate and the transfer-receiving surface of the device substrate. Additionally, a decrease can be attained in the possibility that the vaporized transfer material invades, any one of the divisions, or any different one thereof.

The shape of cross sections of the division pattern is preferably a forward-tapered shape in order to make it easy to deposit the vaporized transfer material evenly onto the device substrate. As has been illustrated in Figs. 2, when the insulating layer 14 or any other pattern is present on the device substrate 10, it is preferred that the width of any region of the division pattern 34 is larger than the width of any region of the insulating layer 14. In the alignment, it is preferred to arrange the substrates to hold the width of any region of the division pattern 34 inside the width of any region of the insulating layer 14. Even when in this case the division pattern 34 is thin, the donor substrate 30 and the device substrate 10 can be kept to have a desired interval therebetween by making the insulating layer 14 thick. Typically, the width of any region of the division pattern is from 5 to 50 µm, and the pitch of the regions thereof is from 25 to 300 µm. However, the values of these factors are not particularly limited; thus, it is advisable to design these factors to show optical values in accordance with the use purpose.

A barrier layer is laid on the division pattern. As described above, the barrier layer is a layer for preventing the elution-out of impurities and others from the division pattern to a solution containing the transfer material. The layer also fulfills a function of preventing a matter that the solvent in the solution containing the transfer material invades the division pattern so that the donor substrate is contaminated or the invading solvent is unfavorably incorporated into a division adjacent thereto.

Examples of the material that forms the barrier layer include metals, metal oxides, metal nitrides, silicon oxides, and silicon nitrides. Frequently, the donor substrate is repeatedly washed and then re-used. Thus, the donor substrate is desired to have durability not to undergo exfoliation of its film(s). It is therefore preferred to select a material high in adhesiveness to the LHCL and the division pattern. Of the above-described examples, metals are preferred from the viewpoint of the adhesiveness, examples thereof including chromium, nickel, zinc, titanium, vanadium, tantalum, and manganese. It is more preferred that the barrier layer and the LHCL are made of the same metal since the barrier layer is further improved in adhesiveness to the LHCL. Other reasons why a metal is preferred for the barrier layer are as follows: the metal is high in density and high in covering performance to restrain the elution-out of low-molecular-weight components largely from the division pattern; and further the metal is elongatable against plastic deformation so that the metal is not easily cracked against thermal stress, thereby producing an advantageous effect from the viewpoint of the elution-out of the impurities.

Plural barrier layers may be laid. In this case, for each of the layers, a material wherein two or more from the above-described materials are freely combined with each other may be used. It is particularly preferred to lay a closely adhesive layer to contact the division pattern or LHCL, and lay a material good in weather resistance as an outermost layer. The closely adhesive layer preferably contains any one of chromium, nickel, zinc, titanium, vanadium, tantalum, and manganese. The front surface thereof may be slightly oxidized or nitrided. It is desired to form, as the outermost layer, a layer of a chemically stable noble metal, such as gold, silver, platinum, palladium, rhodium, iridium, ruthenium or osmium, a metal oxide, a silicon oxide, a silicon nitride, or a metal excellent in acid resistance. Examples of the metal excellent in acid resistance include vanadium, niobium, tantalum, titanium, zircon, hafnium, and tungsten. When a silicon oxide is used for the outermost layer, the material itself has a high barrier performance; however, the silicon oxide itself easily becomes porous. In this case, the surface area unfavorably increases so that the surface reversely easily comes to absorb humidity. Following this, the quantity of ionic impurities remaining on the front surface increases, the impurities being, for example, chorine in the washing, or fluorine in the liquid repellent treatment. Thus, an element into which the impurities will be transferred may be degraded in performance. Thus, it is desired to lay an outermost layer made of a metal, in particular, a noble metal or the like since a smooth surface state is easily created.

The method for forming the barrier layer is not particularly limited, and is generally allowable to be sputtering, vapor deposition, CVD or some other. The thickness is not particularly limited, and is preferably 0.05 µm or more from the viewpoint of the lifetime. In the case illustrated in Fig. 2(a), wherein the barrier layer is formed also in the regions (cells) inward from the division pattern, the thickness of the barrier layer is preferably 0.7 µm or less, more preferably 0.5 µm or less in order to cause an effective thermal conduction of the transfer material from the LHCL to the barrier layer. In the case illustrated in Fig. 2(b), wherein the barrier layer is formed only over the division pattern, the barrier layer can be made ticker to be improved in lifetime. When the barrier layer is formed only over the division pattern, the method for the formation is not particularly limited. An example thereof is a method of using a mask opened only over the division pattern to form the barrier layer only over the division pattern by a vacuum deposition or sputtering process. The formation of the barrier layer only over the division pattern may be attained by forming the barrier layer over the entire front surface of the division pattern, forming a resist by photolithography to make the regions other than the division pattern exposed, and then etching the openings. The barrier layer needs only to cover at least the division pattern. Thus, when the barrier layer is formed also in the regions inward from the division pattern, the layer may be formed on only a portion thereof.

It is preferred to lay, on the front surface of the barrier layer over the division pattern, a liquid repellent treatment layer for repelling a solution wherein the transfer material is dissolved to cause the solution to remain the regions inward the division pattern. The liquid repellent treatment layer preferably has a large contact angle onto a solvent used to dissolve the transfer material. The angle is preferably 40° or more, more preferably 60° or more. It is more preferred that the liquid repellent treatment layer is thinner since the absolute quantity of impurities that may elute out from the layer is smaller. However, if the layer is too thinner, the advantageous effect of the liquid repellent treatment may be damaged. Thus, when the liquid repellent treatment layer is laid, the thickness is preferably from 0.5 to 100 nm both inclusive. When the layer is a monomolecular membrane that will be described later, the thickness is preferably from 1 to 5 nm both inclusive. The liquid repellent treatment layer is not necessarily required to be a continuous film. The layer needs only to have a function of making it possible to cause the solution to be repelled over the barrier layer and attain painting matched with the individual divided regions.

It is desired that the manner for laying the liquid repellent treatment layer is specifically a manner of forming, over the division pattern, an organic film that has a low-surface energy and may be of various types, in particular, a layer of an organic material containing fluorine to cause the upper surface of the division pattern to have a liquid repellent function. An example of the treatment-layer-forming manner is a manner of forming, onto the front surface of the barrier layer on the division pattern, a layer made of, for example, (1) a silicone resin, (2) a fluorine-containing polymeric material, such as fluorinated vinyl resin, or an acrylic resin or polyimide resin containing fluorine in the skeleton thereof, or (3) a coupling agent containing fluorine. In particular, a fluorine-containing silane coupling agent forms a monomolecular membrane on the barrier layer not to adsorb any impurity to the inside thereof, this situation being different from that of any polymeric material. Therefore, when the transfer material is painted, the quantity of impurities which elute out into the solvent is made by far smaller as compared with in the case of other organic polymeric films or silicone films. Thus, this case is particularly preferred. In the liquid repellent treatment layer of a polymeric material, the layer does not have an intense adhesiveness onto the barrier layer, so that when the donor substrate is repeatedly used, the liquid repellent treatment layer may be peeled. In this way, impurities contained in the polymeric material itself elute out gradually through heat or the permeation of the solvent, so as to be incorporated into the transfer material, so that the organic EL element may be degraded in performance. By contrast, about the fluorine-containing silane coupling agent, a film thereof, which has a liquid repellent function and is bondable chemically to the material front-surface of the barrier layer, strongly covers the barrier layer so that the permeation of the solvent is not generated. Thus, the elution-out of the impurities is greatly restrained.

When the fluorine-containing silane coupling agent is illustrated by chemically structural formulae, typical structures thereof are compounds represented by formulae given below. In particular, coupling agents each having a linear perfluoroalkyl group are preferred since the agents make the treatment layer high in adhesive force onto the barrier layer, and improves the device in lifetime.

(1) CF₃CH₂CH₂Si(OCH₃)

(2) CF₃CH₂SiCl₃

(3) CF₃(CF₂)₅CH₂CH₂SiCl₃

(4) CF₃(CF₂)₅CH₂CH₂Si(OCH₃)₃

(5) CF₃(CF₂)₇CH₂CH₂SiCl₃

(6) CF₃(CF₂)₇CH₂CH₂Si(OC₃)₃

(7) CF₃(CF₂)₇CH₂CH₂Si(CH₃)Cl₂

(8) CF₃(CF₂)₇CH₂CH₂Si(CH₃)(OCH₃)₂

(9) (CH₃)₃SiOSO₂CF₃

(10) CF₃CON(CH₃)SiCH₃

(11) CF₃CH₂CH₂Si(OCH₃)₃

(12) CF₃CH₂OSi(OCH₃)₃

(13) CF₃COO(CH₂)₁₅Si(OCH3)₃

(14) CF₃(CF₂)₃₋₁₅CH₂CH₂Si(OCH₃)₃

(15) CF₃(CF₂)₅CH₂CH₂Si(OCH₃)₃

(16) CF₃(CF₂)₇CH₂CH₂Si(OCH₃)₃

(17) CF₃(CF₂)₉CH₂CH₂Si(OCH₃)₃

(18) CF₃(CF₂)₁₁CH₂CH₂Si(OCH₃)₃

(19) CF₃(CF₂)₁₁CH₂CH₂Si(OCH₃)₃

The method for producing the liquid repellent treatment layer onto the division pattern is not particularly limited, and an example thereof is a method of painting a photosensitive resist over the entire front surface of the barrier layer, removing the resist to be opened only over the division pattern, and treating the opened regions. Another example is a method of painting a liquid repellent material onto a film or glass piece, opposing the material to a barrier-layer-laid donor substrate not subjected to any liquid repellent treatment to be bonded to the substrate, and then shifting the liquid repellent material on the film or glass piece onto the division pattern of the donor substrate. Other examples include a method of using ink-jet printing or nozzle-printing using a solvent to paint the liquid-repellent-treatment-material-containing solution only onto the division pattern, and various methods.

### (3) Transfer Material

The transfer material is a material that forms a thin film constituting a device, which typically denotes an organic EL element and further denotes, for example, an organic TFT, a photoelectric transducer, and a sensor that may be of various types. The transfer material may be an organic material, or a metal or any other inorganic material. The material is any material as far as the material is vaporized, sublimated, or sublimated ablatively when heated, or the material makes use of a change in adhesive property or volume to be transferred from the donor substrate to the device substrate. It is also allowable that the transfer material is a precursor of a thin-film-forming material and is converted into the thin-film-forming material by heat or light before or while transferred, thereby forming a transferred layer.

The thickness of the transfer material is varied in accordance with a function thereof or the number of times of the transferring. For example, when a donor material (electron injection material) such as lithium fluoride is transferred, the thickness of the resultant material is sufficient to be 1 nm. When the transfer material is an electrode material, the thickness may be 100 nm or more. About an emissive layer, which is a patterned thin film preferred in the invention, the thickness of the transfer material therefor is preferably from 10 to 100 nm, more preferably from 20 to 50 nm.

The method for forming the transfer material is not particularly limited, and may be a dry process, such as a vacuum deposition, or sputtering process. A method preferred for coping easily with an increase in the size of a device to be produced is a method of painting a solution composed of at least the transfer material and a solvent in the regions inward from the division pattern, drying out the solvent, and then transferring the transfer material. Examples of the method for the painting include ink-jet printing, nozzle-printing, eletropolymerization, electrodeposition, and various printings such as offset, flexographic, planographic, relief, gravure, and screen printings. It is particularly important for the invention that a certain quantity of the transfer material is precisely formed in the individual regions inward from the division pattern. From this viewpoint, a particularly preferred example of the method is ink-jet printing.

If no division pattern is formed, RGB organic EL material layers made from painted solutions contact each other so that boundaries therebetween are not uniform and mixed-layers are formed in a considerable amount. When these material layers are formed to have a gap between each other without contact in order to prevent this inconvenience, it is difficult to make the boundary regions equal to the centers in film thickness. In any case, the boundary regions cannot be transferred since the regions degrade the device in performance. It is therefore necessary to selectively transfer regions narrower in width than any region of the organic EL material pattern. Accordingly, the width of actually usable regions of the organic EL materials becomes narrower. Thus, when an organic EL display is produced, its pixels are unfavorably pixels small in aperture ratio (large in non-emissive region area). The transfer materials need to be transferred in the regions except the boundary region. For the convenience thereof, the transfer materials cannot be transferred at a time; it is therefore necessary to irradiate the R, G and B regions successively to attain transfers independent of each other for these regions, thereby requiring highly precise alignment for high-intensity laser irradiation. In order to solve such a problem, a particularly preferred embodiment of the invention is, for example, an embodiment using a method of using a donor substrate having a division pattern, and transfer materials made from painting solutions to transfer the transfer materials at a time by the above-described method.

In general, when a solution composed of any transfer material and a solvent is applied to a painting process, the solution is frequently adjusted in viscosity, surface tension, dispersibility and the like by the addition of, for example, a surfactant or a dispersing agent thereto. However, in the invention, it is feared that when such additives are present as residues in the transfer material, the residues are taken into the transferred layer, at the transferring time also, to produce a bad effect onto the device performance. It is therefore preferred that the addition or an unintended incorporation of these impurities is made into a minimum level. Thus, after dried, the solution is adjusted to set the purity of the transfer material preferably to 95% or more, more preferably to 98% or more. The adjustment can be attained by setting the proportion of the transfer material in components other than the solvent in the ink to 95% or more by weight.

The solvent may be a known material such as water, or an alcohol, hydrocarbon, aromatic compound, heterocyclic compound, ester, ether or ketone. In ink-jet printing, which is used preferably in the invention, preferred examples of the solvent include N-methylpyrrolidone (NMP), dimethylimidazolidinone (DMI), γ-butyrolactone (γ BL), ethyl benzoate, tetrahydronaphthalene (THN), xylene, and cumene since a solvent having a relatively-high boiling-point of 150°C or higher should be used, and further these solvents are excellent in solubility of the material.

When the transfer material satisfies solubility, transfer resistance, and performances for the device to be produced after transferred, it is preferred to dissolve the transfer material itself (device-constituting material) into the solvent. When the transfer material is poor in solubility, the transfer material can be improved in solubility by introducing a solvent-soluble group such as an alkyl group into the transfer material. Such a material is referred to as a precursor of a transfer material (device-constituting material) in the present specification. By introducing a soluble group into the transfer material when the material is excellent in device performance, the performance may be declined. In this case, this soluble group is eliminated by, for example, heat at the transferring time, so that the original material can be deposited onto the device substrate.

When the soluble-group-introduced transfer material is transferred, the following are preferred for preventing the generation of gas or the incorporation of the eliminated matter into the transferred layer the transfer material has the solvent-soluble group at the painting time; and after the painting, the soluble group is converted or eliminated by heat or light and subsequently the transfer material is transferred. When a material having, for example, a benzene ring or anthracene ring is given as an example, light is irradiated to a material having a soluble group as represented by the formula (1) or (2), whereby the material can be converted into the original material. As shown by the formulae (3) to (6), through a process of introducing an intermolecular crosslinking structure, such as an ethylene group or diketo group, as a soluble group, and eliminating ethylene or carbon monooxide therefrom, a return to the original material can be attained. The conversion or elimination of the soluble group may be performed in the state that the transfer material is a solution before dried, or in the state that the material is a solid after dried. Considering the process stability, this operation is performed in the solid state after the drying. The original molecule of the transfer material is nonpolar in many cases; therefore, in order to cause the eliminated matter not to remain in the transfer material when in the solid state the soluble group is eliminated, it is preferred that the eliminated matter is small in molecular weight, and tends to be polar (repellent to the nonpolar original molecule). In order to remove the eliminated matter together with oxygen and water adsorbed in the transfer material, it is preferred that the eliminated matter is easily reactive with the molecules thereof. From these viewpoints, it is particularly preferred to convert or eliminate the soluble group through a process of eliminating carbon monoxide. This manner can be applied to not only condensed polycyclic hydrocarbon compounds such as naphthacene, pyrene, and perylene, but also condensed polycyclic heteroatom-containing compounds. Of course, these may be substituted or unsubstituted.

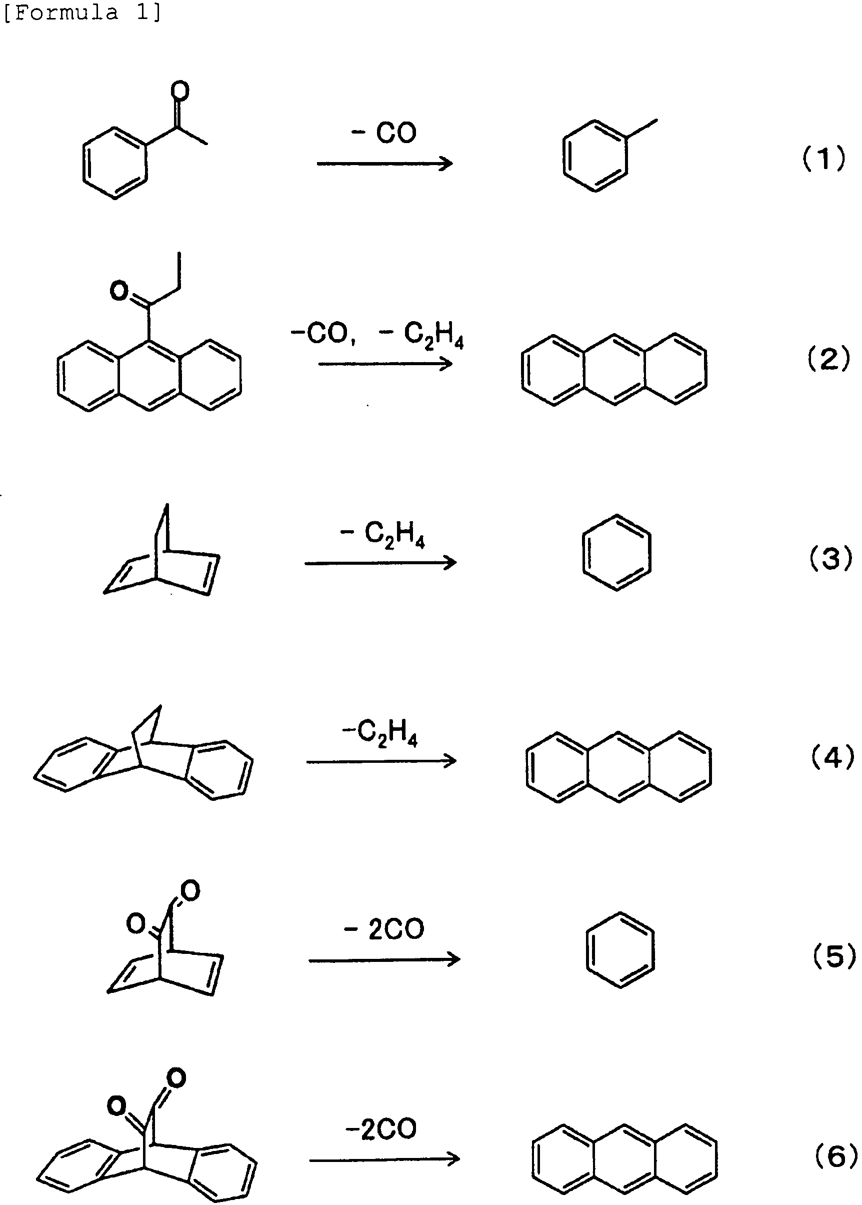

### (4) Device Substrate

The support of the device substrate is not particularly limited, and may be any one of the matters exemplified for the donor substrate. When the two substrates are opposed to each other to transfer the transfer material, in order to prevent a pattern-precision degradation based on a difference in thermal swelling by a change in the temperature, the difference in thermal swelling coefficient between the device substrate and the donor substrate is preferably 10 ppm/°C or less. These substrates are more preferably made of the same material. A glass plate, which is exemplified as a preferred support of the donor substrate, is also a particularly preferred example of the support of the device substrate. The two may be the same or different in thickness.

At the transferring time, the device substrate may be made only of the support. Generally, structural members necessary for the device are beforehand formed on the support. In, for example, the organic EL element illustrated in Fig. 1, members from the first-formed member to the insulating layer 14 or the hole transporting layer 16 are formed by a technique in the prior art, and the resultant may be used as the device substrate.

Structural members, such as the insulating layer, are not essential; however, when the device substrate and the donor substrate are opposed to each other, in order to prevent a matter that the division pattern of the donor substrate contacts the underlayer formed already in the device substrate to scratch the contact regions, it is preferred that the members are beforehand formed in the device substrate. For the formation of the insulating layer, use may be made of the materials, the film-forming methods and the patterning methods exemplified for the division pattern of the donor substrate. About the shape of the insulating layer, the thickness thereof, and the width and pitch thereof also, use may be made of the shapes and the numerical numbers exemplified for the division pattern of the donor substrate.

### (5) Transfer process

The transfer can be performed by opposing the donor substrate and the device substrate to each other in a vacuum, and then taking out the substrates into the atmosphere in the state that the transfer space is kept in the vacuum as it is. For example, using the division pattern of the donor substrate and/or the insulating layer of the device substrate, the space surrounded by these members can be kept into the vacuum. In this case, a vacuum seal function may be fitted to the peripheral of the donor substrate and/or the device substrate. In the case of forming any underlayer of the device substrate, for example, a hole transporting layer through a vacuum process, patterning an emissive layer according to the invention, and forming an electron transporting layer also through a vacuum process, it is preferred to oppose the donor substrate and the device substrate in a vacuum to perform the transfer in the vacuum. In this case, for the method for alignment of the donor substrate and the device substrate highly precisely with each other, and maintaining the opposed state, use may be made of known techniques, such as steps of dropping out a liquid crystal material in a vacuum, and bonding the material, these steps being used in a producing process for a liquid crystal display. Regardless of the transferring atmosphere, the donor substrate may be put into a heat-irradiating state, or cooled at the transferring time. When the donor substrate is re-used, the donor substrate may be used as an endless belt. By using an LHCL made of a good conductor, such as metal, the donor substrate can easily held in an electrostatic manner.

In the invention, transfer in a vapor deposition mode is preferred. It is therefore preferred to pattern a transferred layer of a single layer in one transferring operation. However, when a peeling mode or ablative sublimation mode is used, a transferred layer composed of an emissive layer and an electron transporting layer can be patterned at once, for example, by forming a laminated structure of the electron transporting layer and the emissive layer on the donor substrate, and then transferring the laminated structure in the state that the laminated state is maintained.

The transferring atmosphere may be the atmospheric pressure, or a pressure-reduced atmosphere. In the case of, for example, reactive transfer, the transfer can be performed in the presence of an active gas such as oxygen. In the invention, an object thereof is to decrease a transfer damage of the transfer material. It is therefore preferred to perform the transfer in an inert gas such as nitrogen gas, or in a vacuum. By controlling the pressure appropriately, the modification of an unevenness in the film thickness into evenness can be promoted at the transferring time. It is particularly preferred to perform the transfer in a vacuum to decrease a damage of the transfer material, decrease the incorporation of impurities into the transferred layer and make the vaporizing temperature lower.

In the donor substrate of the invention, the division pattern and the emissive layer are separated from each other by the barrier layer, so that the front surface of the substrate is improved in washability. This matter makes it easy to wash ionic impurities on the front surface of the donor substrate, so that at the time of painting the transfer layer, the incorporation of impurities can be largely decreased. Thus, impurities in the regions inward from the transferred layer can also be decreased. It has been hitherto understood that, in particular, halogens, such as fluorine and chlorine, as impurities decline the performance of the element; thus, according to a transfer process using the donor substrate of the invention, the incorporation of impurities into the element is restrained so that the element performance can be largely improved.

A problem of the prior art which makes direct use of a thin film formed through a painting process as a functional layer of an organic EL element is unevenness in the film thickness. In the invention also, at the time of forming the transfer material through a painting process, substantially the same thickness unevenness is generated. However, in a vapor deposition mode, which is a transfer mode preferred for the invention, the transfer material is disentangled into a molecular (atomic) level and vaporized when transferred, and then the transfer material is deposited onto the device substrate; thus, unevenness in the film thickness of the transferred layer is decreased. Accordingly, even in a case where the transfer material is made of particles each made of a molecule aggregate when painted, an example of this material being a pigment, and further the transfer material is not a continuous film on the donor substrate, a transferred layer excellent in film thickness evenness can be gained on the device substrate by disentangling the aggregate into a molecular level, and then vaporizing and depositing the molecules at the transferring time.

The following will describe a method for manufacturing a devise, using the patterning method of the invention. In the invention, a device typically denotes an organic EL element, and further denotes, for example, an organic TFT, a photoelectric transducer, and a sensor that may be of various types. The invention makes it possible to attain, about an organic TFT, patterning of/into its organic semiconductor layer, insulating layer, various electrodes, such as its source, drain and gate, and others; about an organic solar battery, patterning of/into its electrodes, and others; and about a sensor, patterning of/into its sensing layer and electrodes, and others. Hereinafter, giving an organic EL element as an example, a manufacturing method therefor will be described.

Fig. 1 is a sectional view illustrating a typical structural example of an organic EL element 10 (display). On a support 11 is formed an active matrix circuit composed of TFTs 12, a flattening layer 13 and others. Its element regions are made of the following members formed thereon: each first electrode 15/each hole transporting layer 16/each emissive layer 17/an electron transporting layer 18/a second electrode 19. At the edge of the first electrode, an insulating layer 14 is formed for preventing the generation of a short circuit at the electrode edge, and defining an emissive area. The element structure is not limited to this example. For example, between the first electrode and the second electrode, only one emissive layer may be formed which has both of a hole transporting function and an electron transporting function. Moreover, the hole transporting layer may have a multi-layer-laminated structure of a hole injection layer and a hole transporting layer; and further the electron transporting layer may have a multi-layer-laminated structure of an electron transporting layer and an electron injection layer. When the emissive layer has an electron transporting function, the electron transporting layer may be omitted. Moreover, the above-mentioned members may be laminated in the order of "first electrode/electron transporting layer/emissive layer/hole transporting layer/second electrode". These may each be made of a single layer, or plural layers. After the second electrode is formed, a known technique or the patterning method of the invention may be used to form a protective layer, form a color filter, seal the members, or perform any step, which is not illustrated.

In a color display, at least its emissive layer needs to be patterned. Any emissive layer is a thin film to be preferably patterned in the invention. The patterning of/into, e.g., any insulating layer, first electrode, o r TFT is attained by a known photolithography in many cases; however, the patterning may be attained by a method using the donor substrate of the invention. In the case of needing to attain patterning of/into at least one of any hole transporting layer, electron transporting layer and second electrode, and others, the layer may be patterned by a method using the donor substrate of the invention. It is allowable to pattern, out of emissive layers, only R and G emissive layers by the invention and form, on the entire front surface thereof, a B emissive layer and a layer functioning as both of R and G electron transporting layers.

In an example for manufacturing the organic EL element illustrated in Fig. 1, patterning into members from the first-formed member to the first electrode 15 is attained by photolithography, and then the insulating layer 14 is patterned by a known technique using a photosensitive polyimide precursor material. Thereafter, the hole transporting layer 16 is formed on the entire front surface by a known technique using a vacuum deposition process. This hole transporting layer 16 is used as an underlayer to pattern the emissive layer, i.e., the layers 17R, 17G and 17B by a method using the donor substrate of the invention illustrated in Figs. 2. Over the entire front surface thereof are formed the electron transporting layer 18 and the second electrode 19 by a known technique using a vacuum deposition process or some other. In this way, the organic EL element can be finished.

The emissive layer may be made of a single layer or plural layers. The emissive material of each of the layers may be made of a single material or a mixture of plural material s. From the viewpoint of luminance efficiency, color purity, and lifetime, the emissive layer preferably has a mono-layered structure of a mixture of a host material and a dopant material. Accordingly, a transfer material for forming the emissive layer is preferably a mixture of the host material and the dopant material.

When the transfer material is arranged in regions inward from a division pattern by use of a painting process that will be described later, a mixed solution of a host material and a dopant material is painted and dried to form the transfer material. A solution of the host material and a solution of the dopant material may be separately painted. Even when the host material and the dopant material are not mixed into an even state at the stage of forming the transfer material, the two need only to be mixed in an even state at the transferring time. Using a difference in vaporization temperature between the host material and the dopant material at the transferring time, the concentration of the dopant material in the emissive layer can be varied in the film thickness direction.

Examples of the emissive material include anthracene derivatives, naphthacene derivatives, pyrene derivatives, quinolinol complexes such as tris(8-quinolinolate)aluminum (Alq₃), various metal complexes such as a benzothiazolylphenol zinc complex, bisstyrylanthracene derivatives, tetraphenylbutadiene derivatives, coumalin derivatives, oxadiazole derivatives, benzooxazole derivatives, carbazole derivatives, distyrylbenzene derivatives, pyrrolopyridine derivatives, perynone derivatives, cyclopentadiene derivatives, oxadiazole derivatives, thiadiazolopyridine derivatives, rubrene, quinacridone derivatives, phenoxazone derivatives, perynone derivatives, perylene derivatives, coumalin derivatives, chrysene derivatives, pyrromethene derivatives, iridium complex materials called phosphorescent materials, and other low-molecular-weight materials; and polyphenylene vinylene derivatives, poly-p-phenylene derivatives, and polythiophene derivatives, and other high-molecular-weight materials. Examples of a material that is in particular highly good in luminance performance and is suitable for the patterning method of the invention include anthracene derivatives, naphthacene derivatives, pyrene derivatives, chrysene derivatives, pyrromethene derivatives, and various phosphorescent materials.

The hole transporting layer may be made of a single layer or plural layers. Each of the layers may be made of a single material or a mixture of plural materials. A layer called a hole injection layer may be included in examples of the hole transporting layer. From the viewpoint of hole transporting performance (low driving voltage), and lifetime, an acceptor material may be incorporated into the hole transporting layer to promote the hole transporting performance. Thus, a transfer material for forming the hole transporting layer may be made of a single material or a mixture of plural materials. When the transfer material is arranged in regions inward from a division pattern, the material may be formed by various methods, similarly to the case of the emissive layer.

Examples of the hole transporting material include aromatic amines, typical examples thereof being N,N'-diphenyl-N,N'-dinaphthyl-1,1'-dipehnyl-4,4'-diamine (NPD), N,N'-biphenyl-N,N'-biphenyl-1,1'-diphenyl-4,4'-diamine and N,N'-diphenyl-N,N'-(N-phenylcarbazolyl)-1,1'-diphenyl-4,4'-diamine, N-isopropylcarbazole, pyrazoline derivatives, stylbene compounds, hydrazone compounds, heterocyclic compounds, typical examples thereof including oxadiazole derivatives and phthalocyanine derivatives, and other low-molecular-weight compounds; and polycarbonates or styrene derivatives each having at a side chain thereof such a low-molecular-weight, polyvinyl carbazole, polysilane, and other high-molecular-weight compounds. Examples of the acceptor material include 7,7,8,8-tetracyanoquinodimethane (TCNQ), hexaazatriphenylene (HAT) or a cyano-group-derivative thereof (HAT-CN6), and low-molecular-weight materials. Other examples of the hole transporting material or the acceptor material include metal oxides, such as molybdenum oxide and silicon oxide, which are each made into a thin film on the front surface of the first electrode.

The electron transporting layer may be made of a single layer or plural layers. Each of the layers may be made of a single material or a mixture of plural materials. A layer called a hole blocking layer or an electron injection layer is included in examples of the electron transporting layer. From the viewpoint of electron transporting performance (low driving voltage), and lifetime, a donor material may be incorporated into the electron transporting layer to promote the electron transporting performance. Any layer called an electron injection layer is frequently discussed as this donor material. A transfer material for forming the electron transporting layer may be made of a single material or a mixture of plural materials. When the transfer material is arranged in regions inward from a division pattern, the material may be formed by various methods, similarly to the case of the emissive layer.

Examples of the electron transporting layer include quinolinol complexes such as Alq₃, and 8-quinolinolate lithium (Liq), condensed polycyclic aromatic derivatives such as naphthalene and anthracene, styryl aromatic derivatives, a typical example thereof being 4,4'-bis(diphenylethenyl)biphenyl, quinone derivatives such as anthraquinone and diphenoquinone, phosphorous oxide derivatives, benzoquinolinol derivatives, hydroxyazole derivatives, azomethine derivatives, various metal complexes such as tropolone metal complexes and flavonol complexes, compounds each having a heteroaryl ring structure containing electron acceptable nitrogen, and other low-molecular-weight materials; and high-molecular-weight materials each having at a side chain thereof such a low-molecular-weight compound.

Examples of the donor material include alkali metals or alkaline earth metals such as lithium, cesium, magnesium and calcium; various metal complexes such as quinolinol complexes of these metals; and oxides or fluorides thereof, such as lithium fluoride and cesium oxide. The electron transporting material or donor material is a material that is easily varied in performance by a combination thereof with each of RGB emissive layers. This material is another preferred example patterned by the invention.

At least one of two species of the first electrode (s) and the second electrode(s) is preferably transparent to take out light from the emissive layer. In the case of a bottom emission type, wherein light is taken out from the first electrode(s), the first electrode(s) is/are transparent. In the case of a top emission type, wherein light is taken out from the second electrode(s), the second electrode(s) is/are transparent. When the transfer material is arranged in regions inward from a division pattern, the material may be formed by various methods, similarly to the case of the emissive layer. At the transferring time, for example, the transfer material may be caused to react with oxygen. In this way, or some other way, reactive transfer can be performed. For the material of the transparent electrode(s), and the other electrode species, a material known in the prior art may be used, as described in, for example, JP-A-11-214154.

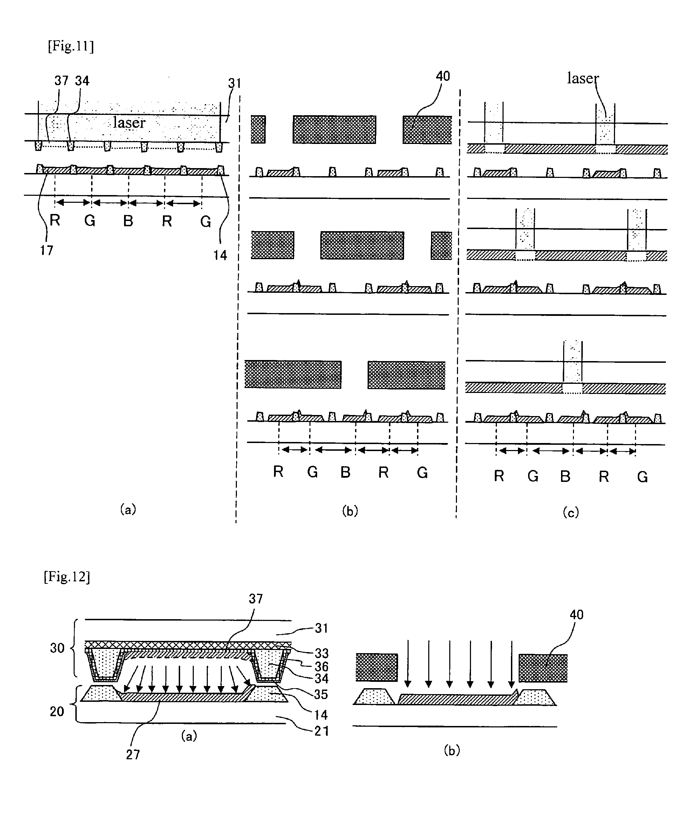

An organic EL element manufactured by use of the donor substrate of the invention has characteristics described hereinafter. When its transfer layers are emissive layers (R, G and B), the emissive layers transferred onto its device substrate by the irradiation of a laser trace the pattern of the donor substrate. In other words, as illustrated in Fig. 11 (a), by use of a donor substrate wherein emissive layers are patterned to give regular intervals therebetween, the respective intervals between adjacent ones of the emissive layers become substantially constant. In Fig. 11(a), broken lines extended toward spots described as Rs, Gs and Bs, respectively, show the respective central positions in the width direction of the individual emissive layers R, region G and regions B. The respective distances between the central positions of adjacent ones of the emissive layer regions are substantially regular. In Fig. 11(a) is shown an embodiment wherein a laser is irradiated in the same manner as in Figs. 2 and 3. However, even an embodiment wherein a different irradiating manner is used produces the same results, the embodiment being, for example, an embodiment wherein conditions are adjusted to irradiate a portion of the division pattern and the transfer layers with a laser, and then the laser is scanned in the direction in which the R, G and B regions are arranged.

In Fig. 11(b) is shown a case where emissive layers are formed by a vapor deposition process. Therein, at the time of the vapor deposition of each of R, G and B, the alignment of a mask is required. It is however difficult to attain the alignment completely. At moieties where an error of the mask position is generated, R, G and B regions may not be arranged to have regular intervals therebetween. In Fig. 11 (c) is shown a method of forming R, G and B emissive layers onto three donor substrates having no division pattern, respectively, and then performing partial transfers. In this case, it is difficult to attain completely alignment for performing laser-irradiation three times. Thus, similarly to the case of vapor deposition, R, G and B regions may not be arranged to have regular intervals therebetween. From this matter, it is understood that in a transfer process using the donor substrate of the invention, R, G and B are patterned with a high precision so that the intervals therebetween can be made substantially regular.

The following will describe other characteristics of the organic EL element manufactured through transfer process by use of the donor substrate of the invention. As illustrated in Fig. 12(a), transfer by use of a laser is characterized in that in an object which has received the transfer, at the edge of its transferred layer 27, the film thickness is gently decreased (in Fig. 12(a), at first sight, each edge of a pattern swells relatively to the center; however, at the edge, a division pattern having forward-tapered edge forms is present so that the film thickness of the transferred layer is gently decreased toward the edges). By contrast, as illustrated in Fig. 12(b), according to mask vapor deposition, molecules for an emissive layer comes flying straightly from a vapor deposition source to be deposited onto a substrate. Thus, at the edges, the film thickness is sharply decreased. When the edges of a transferred layer are observed as described herein, it can be distinguished whether the film is formed by vapor deposition or transfer process.

As described above, about the organic EL element of the invention, even when at least one of its organic compound layers is formed through a transfer process, impurities incorporated into the organic compound layer, typical examples thereof being halogens, are largely decreased in quantity. Thus, the element shows an excellent luminance performance. Such an organic EL element is preferably, for example, an organic EL element having organic compound layers including an emissive layer sandwiched between at least one pair of electrodes, wherein one or more of the organic compound layers are formed through a transfer process and any one of the following is satisfied:
(1) in the layer (s) formed through the transfer process, the ratio of the fluorine intensity to the carbon intensity is 1 x 10⁻¹ or less, the intensities being by elementary analysis based on SIMS, and
(2) in the layer(s) formed through the transfer process, the ratio of the chlorine intensity to the carbon intensity is 5 x 10⁻³ or less, the intensities being by the SIMS elementary analysis.

This organic EL element is more preferably an organic EL element satisfying the items (1) and (2), and is even more preferably an organic EL element wherein the layer(s) formed through the transfer process is an emissive layer.

The fluorine, chlorine and carbon intensities are each the intensity of a peak in the SIMS elementary analysis. The ratio of the fluorine intensity or chlorine intensity to the carbon intensity is a value obtained by dividing the fluorine intensity or chlorine intensity by the carbon intensity. In ordinary organic EL emissive materials, the respective concentrations of carbon contained in the materials are substantially the same regardless of the species of the materials, so that the carbon intensities detected by SIMS are values close to each other regardless of the materials. Thus, each of the carbon intensities can be used as a standard value.

In the organic EL element, elementary analysis based on SIMS of, for example, its emissive layer may be made, for example, as follows: The organic EL element is etched in the depth direction from the cathode or anode to the inside. In this way, a region of the emissive layer is made exposed, and then ions are irradiated onto the surface. Elements released therefrom are detected in a mass spectrometer. For an organic EL element having many organic layers formed, the method for detecting a region corresponding to its emissive layer is not particularly limited. When the emissive layer has an element distinctive to the layer or a concentration distribution thereof, an example of the method is a method of observing the element or the distribution by SIMS to detect the emissive layer region. This method is simple and easy since the detection can be attained simultaneously with the above-described elementary analysis. Another example thereof is a method of cutting the organic EL element obliquely to the laminate direction, and subjecting one of the resultant cut surfaces to analysis about luminescence, such as photoluminescence or cathode luminescence. This method makes it possible to observe luminescence-recognized moieties corresponding to the luminance color. From this result, the electrode position in the obliquely cut surface, and the inclination of the cutting, the position of the emissive layer can be calculated out. The position of the emissive layer may be detected by observing the structure of the organic layer, using a TEM or SEM of a cross section of the organic EL element. It is preferred to combine these manners with each other to detect the position of the emissive layer, and measure elements inside the emissive layer at the emissive layer position recognized from synthetic judgment by SIMS.

As has already been described, such an organic EL element can be manufactured by use of the donor substrate of the invention. However, the manufacturing method is not limited to the described method. In the case of using a transfer process using a donor substrate having a division pattern, an organic EL element having substantially the same characteristics can be manufactured by using a donor substrate having a structure capable of restraining impurities from eluting out from the division pattern.

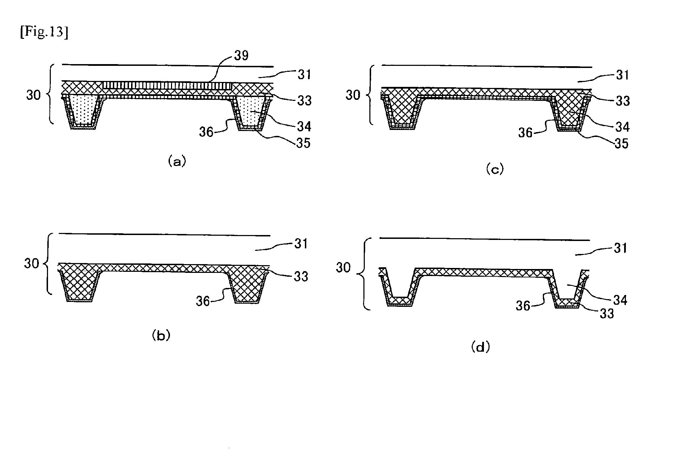

Examples of a structure capable of decreasing the elution-out of impurities from a division pattern or some other are illustrated in Figs. 13. Fig. 13 (a) illustrates an example of a structure wherein the donor substrate of the invention is improved. An antireflective layer 39 is formed between an LHCL 33 and a support 31 to improve the absorptivity of light. When a material from which impurities elutes out easily is used for the antireflective layer 39, some impurities that can not be blocked by only the LHCL 33, out of the impurities, can be blocked by a barrier layer 35. Fig. 13(b) illustrates a structure wherein an LHCL 33 itself is patterned to function also as a division pattern. Since a division pattern from which impurities elute out easily is not present, no barrier layer is laid. Of course, as illustrated in Fig. 13(c), a barrier layer may be further laid on an LHCL 33, for example, when impurities may unfavorably elute out also from the LHCL 33. Fig. 13(d) illustrates a structure wherein a support 31 is worked to have irregularities, thereby causing the irregularities to function also as a division pattern. In this case also, no barrier layer is laid since a division pattern from which impurities elute out easily is not present. In the same manner, a barrier layer may be further laid.

The organic EL element of the invention is not limited into any active matrix type, wherein a second electrode is generally formed as a common electrode. The element may be, for example, of a passive matrix type, which has stripe-form electrodes wherein first electrodes cross second electrodes, or a segment type, wherein a display section is patterned to display information pieces beforehand decided. Examples of articles wherein these types are used include a television, a personal computer, a monitor, a clock or watch, a thermometer, an audio instrument, and a display panel for an automobile.

A patterning method using the donor substrate of the invention may be applied to not only organic EL elements, but also organic TFTs, photoelectric transducers, various sensors and other devices. As exemplified as known techniques in JP-A-2003-304014, JP-A-2005-232136, and JP-A-2004-266157 and others, the following method is disclosed: a method of painting a precursor material of a semiconductor directly onto a device substrate, and converting the material to form a semiconductor layer. When this semiconductor layer is formed by a patterning method using the donor substrate of the invention, the same advantageous effects as gained by the organic EL element can be gained.

### EXAMPLES

Hereinafter, the invention will be described by way of working examples. However, the invention is not limited to the examples.

### Example 1

A donor substrate was formed as follows: As a support, a non-alkali glass substrate was used, and subjected to washing/UV ozone treatment. A titanium film 1. 0 µm in thickness was then formed as an LHCL onto the entire front surface by sputtering. Next, the LHCL was subjected to UV ozone treatment, and then a positive polyimide based photosensitive coating agent (DL-1000 manufactured by Toray Industries Inc.) was painted thereon by spin coating. The workpiece was pre-baked and exposed to UV, and then the exposed regions were dissolved and removed with a developing solution (ELM-D, manufactured by Toray Industries Inc.). The thus patterned polyimide precursor film was baked on a hot plate at 350°C for 10 minutes to form a polyimide based division pattern. This division pattern had a thickness of 2 µm, and cross sections thereof each had a forward-tapered form. The width of any region thereof was 20 µm. In regions inward from the division pattern, openings for making patterned regions of the LHCL that each had a width of 80 µm and a length of 280 µm exposed were arranged at a pitch of 100 µm and a pitch of 300 µm, respectively. Furthermore, a metal layer of tantalum was formed as a barrier layer onto the entire front surface by sputtering to give a thickness of 0.4 µm. A positive photosensitive resist (PMER-P300RH, manufactured by Tokyo Ohka Kogyo Co., Ltd.) was painted onto the front surface, and the regions other than the division pattern region were exposed to light and dissolved to be removed. A fluorine liquid repellent treatment agent (FG-5010, manufactured by Fluoro Technology Co., Ltd.) of a perfluorosilane coupling agent (fluorine-containing silane coupling agent) was painted on the openings in the resist by spin coating, and then an unnecessary volume of the agent was washed out with water. The photoresist was then peeled. Onto this substrate was painted a xylene solution containing 1 wt% of Alq₃ by ink-jet printing, so as to form a transfer material made of Alq₃ and having an average thickness of 25 nm in the regions (openings) inward from the division pattern.

After the painting onto the donor substrate by the ink-jet printing, an apparatus TOF. SIMS5 manufactured by ION-TOF Co. was used to subject the transfer material region surface of the regions inward from the division pattern to TOF-SIMS analysis. As a result, as impurities, Si (CH₃) ₃⁺ with 1e-3 [peak intensity] was detected, as well as CF₃⁺ with 3e-3 [peak intensity]. In each of Examples 2 to 6 and Comparative Example 1 described below, the quantity of the impurities detected in Example 1 was regarded as 1, and the relative quantity of impurities was estimated.

A device substrate was formed as follows: A product (sputtering-deposited-film attached product, manufactured by Geomatec Co. , Ltd.), wherein an ITO transparent conductive film is deposited on a non-alkali glass substrate to have a thickness of 140 nm, was cut into a size of 38 x 46 mm. The ITO was etched into a desired form by photolithography. Next, a polyimide precursor film made into the same pattern as formed in the donor substrate was baked at 300°C for 10 minutes to form a polyimide based insulating layer. The height of this insulating layer was 1.8 µm, and cross sections thereof each had a forward-tapered form. The width of the form was 30 µm. In regions inward from the pattern of the insulating layer, openings for making regions of the ITO that each had a width of 70 µm and a length of 270 µm exposed were arranged at a pitch of 100 µm and a pitch of 300 µm, respectively. This substrate was subjected to UV ozone treatment and set in a vacuum deposition apparatus. The apparatus was degassed into a vacuum degree of 3 x 10⁻⁴ Pa or less. Through a resistance-heating evaporation process, copper phthalocyanine (CuPc) and NPD were laminated as hole transporting layers onto the entire front surface of the emissive region by vapor deposition to have thicknesses of 20 nm and 40 nm, respectively.

Next, the position of the division pattern of the donor substrate was matched with that of the insulating layer of the device substrate, and then the substrates were opposed to each other. This workpiece was held in a vacuum having a pressure of 3 x 10⁻⁴ Pa or less, and then taken out into the atmosphere. The transfer spaces divided by the insulating layer and the division pattern were kept into a reduced pressure. In this state, a laser having a central wavelength of 800 nm (light source: semiconductor laser diode) was irradiated onto the workpiece from the glass substrate side of the donor substrate to heat a portion of the transfer material and a portion of the division pattern simultaneously. In this way, Alq₃ of the transfer material was transferred onto the hole transporting layer as the underlayer of the device substrate. The laser intensity was about 300 W/mm², and the scanning speed was 1.25 m/s. The laser was repeatedly scanned in a laser-overlapping manner to transfer the transfer material onto the entire front surface of the emissive region.

The Alq₃-transferred device substrate was again set inside the vacuum deposition apparatus, and the apparatus was degassed into a vacuum degree of 3 x 10⁻⁴ Pa or less. Through a resistance-heating evaporation process, a compound E-1 illustrated below was evaporated and deposited as an electron transporting layer into a thickness of 25 nm onto the entire front surface of the emissive region. Next, lithium fluoride and aluminum were evaporated and deposited as a donor material (for electron injection layer) and for a second electrode, respectively, thereonto to have thicknesses of 0.5 nm and 100 nm, respectively. In this way, an organic EL element wherein the emissive region was a region 5 mm square was manufactured.

An SIMS (secondary ion mass spectrometer) apparatus, ADEPT1010 manufactured by Physical Electronics Inc. (PHI Inc.), was used to etch the organic EL element from the cathode side thereof with ions to make the transferred emissive layer exposed. This moiety was subjected to element analysis. Cesium ions were irradiated thereonto at 3 keV. The respective detected intensities of fluorine, chlorine and carbon elements detected at this time were compared with each other. As a result, the fluorine intensity relative to the carbon intensity was 1 x 10⁻¹ or less, and the chlorine intensity relative to the carbon intensity was 5 x 10⁻³ or less. The position of the emissive layer was beforehand specified by a method of cutting the element obliquely and measuring photoluminescence therefrom, thereby calculating out the depth thereof from the cathode.

A constant current of 2.5 mA/cm² was applied to this element. As a result, an initial luminance was 5 cd/A. The luminance just after starting to apply the current was defined as the initial luminance, and the value obtained by dividing the initial luminance by the current density was defined as the initial luminance efficiency. Furthermore, the constant current was continuously applied, and a measurement was made about the period until the luminance was lowered to 1/2 of the initial luminance, the period being defined as the luminescence half-life time. In each of Examples 2 to 6 and Comparative Example 1 described below, the initial luminance efficiency and the luminescence half-life time in Example 1 were each regarded as 1, and the relative initial luminance efficiency and the relative luminescence half-life time were estimated.

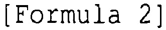

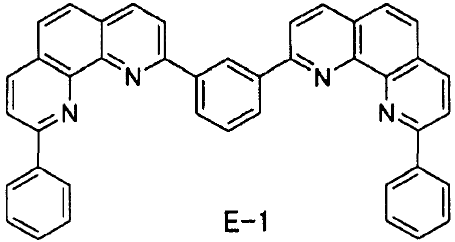

### Example 2

Molybdenum was formed into a barrier layer having a thickness of 0.4 µm, and photolithographic technique was used to etch the molybdenum through only openings with a ferric chloride solution. In this way, the barrier layer was laid only on the division pattern. In the same way as in Example 1 except this step, an organic EL element was manufactured. In the same way as in Example 1, the impurity quantities in the transfer material in the donor substrate were analyzed, the initial luminance efficiency and the luminescence half-life time of the organic EL element were measured, and further an SIMS measurement in the emissive layer of the organic EL element was made. The results are together shown in Table 1.

### Example 3

Silicon dioxide was formed into a barrier layer having a thickness of 0.4 µm. In the same way as in Example 1 except this step, an organic EL element was manufactured. In the same way as in Example 1, the impurity quantities in the transfer material in the donor substrate were analyzed, the initial luminance efficiency and the luminescence half-life time of the organic EL element were measured, and further an SIMS measurement in the emissive layer of the organic EL element was made. The results are together shown in Table 1. The elution-out of impurities, such as CF₃, from the division pattern was restrained. However, the silicon oxide front surface was porous; thus, a large quantity of chorine was detected, which appeared to remain when the substrate was washed.

### Example 4

An organic EL element was manufactured in the same way as in Example 1 except that a liquid repellent treatment agent (FG-1010, manufactured by Fluoro Technology Co., Ltd.) of a fluorine-containing high-molecular-weight material was used to apply a liquid repellent treatment directly only onto the division pattern. In the same way as in Example 1, the impurity quantities in the transfer material in the donor substrate were analyzed, the initial luminance efficiency and the luminescence half-life time of the organic EL element were measured, and further an SIMS measurement in the emissive layer of the organic EL element was made. The results are together shown in Table 1.

### Example 5

An attempt was made for manufacturing an organic EL element in the same way as in Example 1 except that a silicone resin (SD4580, manufactured by Dow Corning Toray Co., Ltd.) was painted to be made into a liquid repellent treatment layer onto the barrier layer of the donor substrate. However, when the emissive material was painted on the donor substrate by ink-jet printing, the ink soaked into the liquid repellent layer to generate portions in each of which the color of the ink was mixed with the color of the painted layer in a division adjacent thereto. In the same way as in Example 1, the impurity quantities in the transfer material in the donor substrate were analyzed, the initial luminance efficiency and the luminescence half-life time of the organic EL element were measured, and further an SIMS measurement in the emissive layer of the organic EL element was made. The results are together shown in Table 1.

### Example 6

An attempt was made for manufacturing an organic EL element in the same way as in Example 1 except that the liquid repellent treatment was not applied to the donor substrate. The transfer material got over the division pattern to spread into an adjacent division so that the material wetted and coated the adjacent division. Thus, color mixing should have been fundamentally caused to result in a painting defectiveness. In the present example, however, the same color was painted onto all the divisions so that no problem was caused. Thus, an originally-conceived process was advanced. In the same way as in Example 1, the impurity quantities in the transfer material in the donor substrate were analyzed, the initial luminance efficiency and the luminescence half-life time of the organic EL element were measured, and further an SIMS measurement in the emissive layer of the organic EL element was made. The results are together shown in Table 1.

### Comparative Example 1

An organic EL element was manufactured in the same way as in Example 1 except that the division pattern made of the polyimide was formed on the donor substrate, and then without performing the step of forming the barrier layer nor the subsequent steps, the transfer material was painted directly onto the division pattern. In the same way as in Example 1, the impurity quantities in the transfer material in the donor substrate were analyzed, the initial luminance efficiency and the luminescence half-life time of the organic EL element were measured, and further an SIMS measurement in the emissive layer of the organic EL element was made. The results are together shown in Table 1.

### Example 7

An organic EL element was manufactured in the same way as in Example 1 except that the following was painted by ink-jet printing: a xylene solution wherein solutes were contained in a total concentration of 1 wt% and the solutes included, as a transfer material, Alq₃ containing rubrene in a concentration of 5 wt%. In the same way as in Example 1, the impurity quantities in the transfer material in the donor substrate were analyzed, the initial luminance efficiency and the luminescence half-life time of the organic EL element were measured, and further an SIMS measurement in the emissive layer of the organic EL element was made. The results are together shown in Table 1. The quantity of the impurities detected in Example 1 was regarded as 1, and the relative impurity quantity was estimated. The initial luminance efficiency was 6 cd/A. In Comparative Example 2 described below, the initial luminance efficiency and the luminescence half-life time in Example 7 were each regarded as 1, and the relative initial luminance efficiency and the relative luminescence half-life time were estimated.

### Comparative Example 2

An organic EL element was manufactured in the same way as in Comparative Example 1 except that the following was painted by ink-jet printing: a xylene solution wherein solutes were contained in a total concentration of 1 wt% and the solutes included, as a transfer material, Alq₃ containing rubrene in a concentration of 5 wt%. In the same way as in Example 1, the impurity quantities in the transfer material in the donor substrate were analyzed, the initial luminance efficiency and the luminescence half-life time of the organic EL element were measured, and further an SIMS measurement in the emissive layer of the organic EL element was made. The results are together shown in Table 1.

### Example 8

An organic EL element was manufactured in the same way as in Example 1 except that the following was painted by ink-jet printing: a xylene solution wherein solutes were contained in a total concentration of 1 wt% and the solutes included, as a transfer material, a compound RH-1 illustrated below containing a compound RD-1 illustrated below in a concentration of 0.5 wt%. In the same way as in Example 1, the impurity quantities were analyzed, the initial luminance efficiency and the luminescence half-life time were measured. The results are together shown in Table 1. The quantity of the impurities detected in Example 1 was regarded as 1, and the relative impurity quantity was estimated. The initial luminance efficiency was 5 cd/A. In Comparative Example 3 described below, the initial luminance efficiency and the luminescence half-life time in Example 7 were each regarded as 1, and the relative initial luminance efficiency and the relative luminescence half-life time were estimated. In Example 8 and Comparative Example 3 described just below, free fluorine was unable to be micro-analyzed since any molecule of the RD-1 contains fluorine, which is not an impurity. Thus, only chlorine was analyzed.

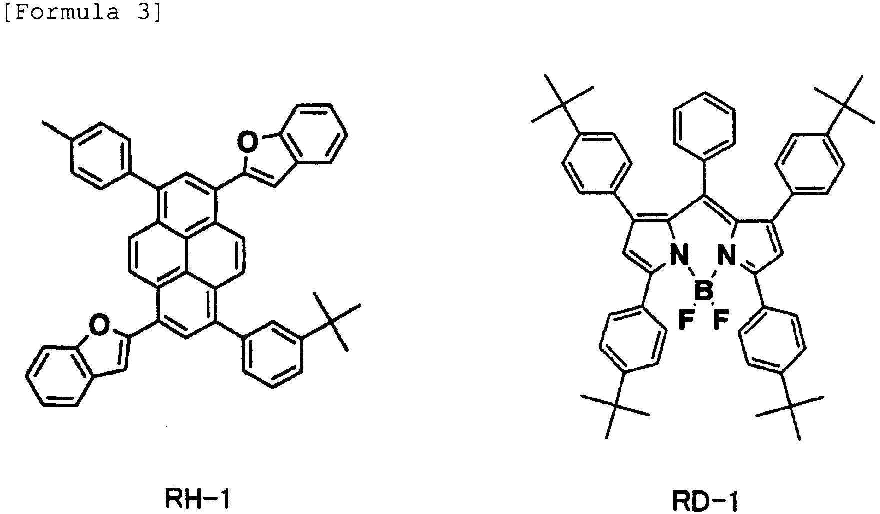

### Comparative Example 3

An organic EL element was manufactured in the same way as in Comparative Example 1 except that the following was painted by ink-jet printing: a xylene solution wherein solutes were contained in a total concentration of 1 wt% and the solutes included, as a transfer material, the compound RH-1 illustrated below containing the RD-1 illustrated below in a concentration of 0.5 wt%. In the same way as in Example 1, the impurity quantities were analyzed, the initial luminance efficiency and the luminescence half-life time were measured. The results are together shown in Table 1.

The results of Examples and Comparative Examples demonstrate that in any case where a barrier layer was laid on a division pattern, the quantity of impurities was smaller and the organic EL element showed better performances than in the case of Comparative Examples whether the barrier-layer-laid region was the entire surface or only on the division pattern. Regardless of transfer material species, substantially the same tendency was verified. In connection with liquid repellent treatment layers, organic EL elements showed better performances in the order toward 1. a fluorine-containing silane coupling agent treatment, through 2. a fluorine-containing high-molecular-weight liquid repellent treatment, from 3. a fluorine-free high-molecular-weight liquid repellent treatment. Since the impurities quantity became larger in the order from 1 to 3, it was verified that the restrain of the elution-out of impurities contributes largely to a rise in the performance of an organic EL element.

An EL element may be driven at a high electric current to keep a necessary light quantity, correspondingly to a recent require for an improvement on the luminance for improving the perceptibility. It has been experientially known that the life time is generally in inverse proportion to the 1.6th power of the current value. When an organic EL element is used in a high current range, the effect of a decline in the performance thereof is enlarged. Thus, even when the performance proportion about life time is from about 80 to 95% of the performance of Example 1 as seen in Examples 3 to 5, the luminescence half-life time becomes 70% or less of that of Example 1, for example, in a high current range two times higher the current range. Thus, this case is largely poor for practical use. In the comparative examples, wherein the performance proportion about life time is about 70% of the performance of Example 1, the luminescence half-life time becomes 30% or less of that of Example 1 in the high current range two times higher the current range. Thus, the luminance efficiency is poorer so that the comparative examples are unsuitable for practical use.

**[Table 1]**

| | Transfer material | Relative initial luminance efficiency | Relative luminescence half-life time | Relative impurity quantity | | Intensity Ratio of impurity to carbon after transfer | |
|---|---|---|---|---|---|---|---|
| | | | | CF₃⁺ | Si (CH₃) ₃⁺ | Fluorine [x 10⁻¹] | Chlorine (x 10⁻³] |
| Example 1 | Alq₃ | 1 | 1 | 1 | 1 | 1 or less | 5 or less |
| Example 2 | Alq₃ | 1 | 1 | 1 | 1 | 1 or less | 5 or less |
| Example 3 | Alq₃ | 1 | 0.8 | 1 | 1 | 1 or less | 15 |
| Example 4 | Alq₃ | 1 | 0.95 | 3 | 1 | 10 | 5 or less |
| Example 5 | Alq₃ | 0.95 | 0.9 | 1 | 10 | 1 or less | 7 |
| Example 6 | Alq₃ | 1 | 1 | 1 | 1 | 1 or less | 5 or less |
| Comparative Example 1 | Alq₃ | 0.8 | 0.7 | 15 | 1.5 | 30 | 100 |
| Example 7 | Alq₃ + Rubrene | 1 | 1 | 1 | 1 | 1 or less | 5 or less |
| Comparative Example 2 | Alq₃ + Rubrene | 0.85 | 0.7 | 15 | 1.5 | 30 | 100 |
| Example 8 | RH1 + RD1 | 1 | 1 | 1 | 1 | - | 5 or less |
| Comparative Example 3 | RH1 + RD1 | 0.8 | 0.7 | 15 | 1.5 | - | 100 |

### INDUSTRIAL APPLICABILITY

The invention is a patterning technique for a thin film which constitutes a device, examples of which typically including organic EL elements and further including organic TFTs, photoelectric transducers, and various sensors. The invention may be used for manufacturing display panels used in portable telephones, personal computers, televisions, image scanners and others, as well as in touch panel, image pickup elements and others.

### DESCRIPTION OF REFERENCE SIGNS

- 10:: Organic EL element (device substrate)
- 11:: Support
- 12:: TFT (including a leading-out electrode)
- 13:: Flattening layer
- 14:: Insulating layer
- 15:: First electrode
- 16:: Hole transporting layer
- 17:: Emissive layer
- 18:: Electron transporting layer
- 19:: Second electrode
- 20:: Device substrate
- 21:: Support
- 27:: Transferred layer
- 30:: Donor substrate
- 31:: Support
- 33:: LHCL
- 34:: Division pattern
- 35:: Barrier layer
- 36:: Liquid repellent treatment layer
- 37:: Transfer material
- 38:: Transfer region
- 39:: Antireflective layer
- 40:: Mask

## Claims

1. A donor substrate (30) for transfer, comprising: a substrate, a light-to-heat conversion layer (33) formed over the substrate, and a division pattern (34) that is at least partially formed over an upper surface of the light-to-heat conversion layer (33), wherein a barrier layer (35) is formed over a front surface of the division pattern (34).

2. The donor substrate for transfer according to claim 1, wherein a transfer layer is formed in one or more regions inward from the division pattern (34).

3. The donor substrate for transfer according to claim 1 or 2, wherein the barrier layer (35) comprises any one of metals, metal oxides, metal nitrides, silicon oxides, and silicon nitrides.

4. The donor substrate for transfer according to any one of claims 1 to 3, wherein the barrier layer (35) comprises a metal.

5. The donor substrate for transfer according to any one of claims 1 to 4, wherein a liquid repellent treatment layer (36) is formed over at least one portion of a front surface of the barrier layer (35) over the division pattern (34).

6. The donor substrate for transfer according to claim 5, wherein the liquid repellent treatment layer (36) is a layer treated with a silane coupling agent containing fluorine.

7. The donor substrate for transfer according to any one of claims 1 to 6, wherein the transfer layer comprises a device-constituting material or a precursor material thereof.

8. A method for manufacturing a device, comprising the step of opposing the donor substrate (30) for transfer recited in any one of claims 1 to 7 to a device substrate (10), and the step of irradiating light to the light-to-heat conversion layer (33) to transfer the transfer layer onto the device substrate (10) .

9. The method for manufacturing a device according to claim 8, the transfer layer comprising a precursor material of a device-constituting material, and the method further comprising the step of converting the precursor material to the device-constituting material.

10. The method for manufacturing a device according to claim 9, wherein the precursor material of the device-constituting material is a material wherein a soluble group is introduced to a transfer material.

11. The method for manufacturing a device according to any one of claims 8 to 10, wherein the device is an organic EL element.

12. An organic EL element, comprising one or more organic compound layers comprising an emissive layer (17) sandwiched with at least one pair of electrodes ((15), (19)), the organic compound layer(s) being at least partially formed through a transfer process, wherein: the ratio of the intensity of fluorine to that of carbon is 1 x 10⁻¹ or less in the layer(s) formed through the transfer process, these intensities being detected by elementary analysis based on SIMS; or the ratio of the intensity of chlorine to that of carbon is 5 x 10⁻³ or less in the layer(s) formed through the transfer process, these intensities being detected by elementary analysis based on SIMS.

13. The organic EL element according to claim 12, wherein the layer (s) formed through the transfer process is/are an emissive layer (17).

14. The organic EL element according to claim 13, wherein the emissive layer (17) is patterned into emissive layers, and the interval between adjacent ones of the emissive layers is substantially regular.
